(19) Europäisches Patentamt
European Patent Office
Office européen des brevets

(11) **EP 2 104 936 B1**

(12) **FASCICULE DE BREVET EUROPEEN**

(45) Date de publication et mention de la délivrance du brevet:
**16.02.2011 Bulletin 2011/07**

(21) Numéro de dépôt: **07871956.4**

(22) Date de dépôt: **18.12.2007**

(51) Int Cl.:
**G10L 19/02** *(2006.01)*

(86) Numéro de dépôt international:
**PCT/FR2007/052541**

(87) Numéro de publication internationale:
**WO 2008/081144 (10.07.2008 Gazette 2008/28)**

(54) **CODAGE PAR TRANSFORMEE, UTILISANT DES FENETRES DE PONDERATION ET A FAIBLE RETARD**

TRANSFORMATIONSKÖDIERUNG MIT GERINGER VERZÖGERUNG UNTER VERWENDUNG VON GEWICHTGSFENSTERN

LOW-DELAY TRANSFORM CODING USING WEIGHTING WINDOWS

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **05.01.2007 FR 0700056**
**17.04.2007 FR 0702768**

(43) Date de publication de la demande:
**30.09.2009 Bulletin 2009/40**

(73) Titulaire: **FRANCE TELECOM**
**75015 Paris (FR)**

(72) Inventeurs:
• **KOVESI, Balazs**
**F-22300 Lannion (FR)**
• **VIRETTE, David**
**F-22560 Pleumeur Bodou (FR)**
• **PHLIPPE, Pierrick**
**F-35520 Melese (FR)**

(74) Mandataire: **Cabinet Plasseraud**
**52, rue de la Victoire**
**75440 Paris Cedex 09 (FR)**

(56) Documents cités:
**WO-A-98/02971    US-A- 5 361 278**

• **OMAR NIAMUT ET AL: "RD OPTIMAL TIME SEGMENTATIONS FOR THE TIME-VARYING MDCT" PROCEEDINGS OF THE EUROPEAN SIGNAL PROCESSING CONFERENCE, XX, XX, 6 septembre 2004 (2004-09-06), pages 1649-1652, XP002391769**
• **EDLER B: "CODIERUNG VON AUDIOSIGNALEN MIT UEBERLAPPENDER TRANSFORMATION UND ADAPTIVEN FENSTERFUNKTIONEN CODING OF AUDIO SIGNALS WITH OVERLAPPING BLOCK TRANSFORM AND ADAPTIVE WINDOW FUNCTIONS" FREQUENZ, SCHIELE UND SCHON, BERLIN, DE, vol. 43, no. 9, 1 septembre 1989 (1989-09-01), pages 252-256, XP000052987 ISSN: 0016-1136**

**Description**

La présente invention concerne le décodage de signaux audionumériques.

Dans un schéma de codage par transformée, pour une réduction de débit, on cherche habituellement à réduire la précision accordée au codage des échantillons, en s'assurant que l'auditeur ne puisse toutefois percevoir que le moins possible de dégradations.

À cette fin, la réduction de précision, effectuée par une opération de quantification, est contrôlée à partir d'un modèle psychoacoustique. Ce modèle, basé sur une connaissance des propriétés de l'oreille humaine, permet de doser le bruit de quantification dans les fréquences auditives les moins perceptibles.

Afin d'utiliser les informations issues du modèle psychoacoustique, essentiellement données dans le domaine fréquentiel, il est classique de réaliser une transformation temps/fréquence, la quantification s'effectuant dans ce domaine fréquentiel.

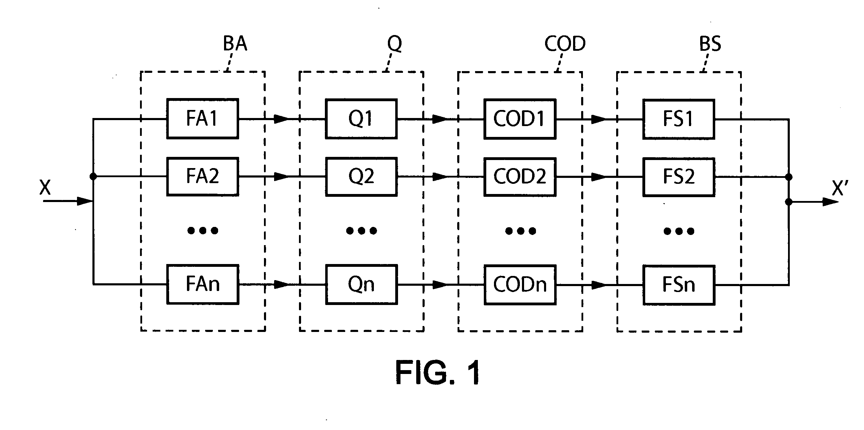

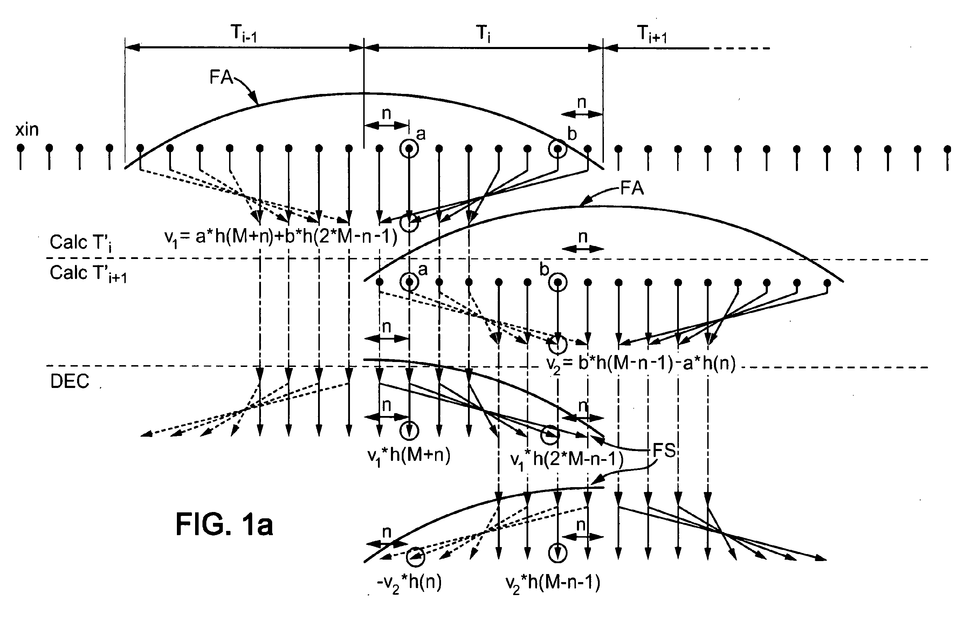

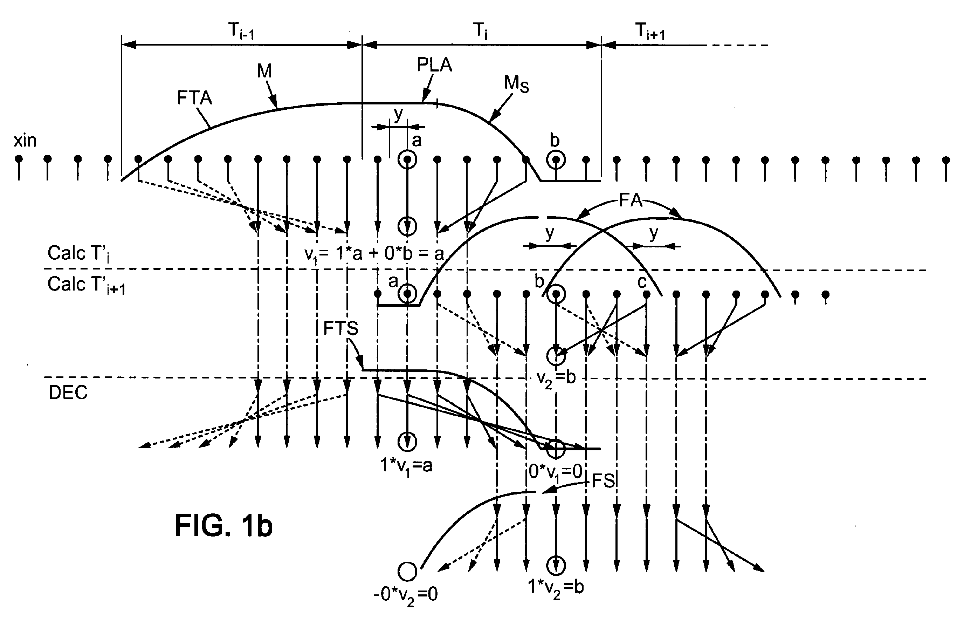

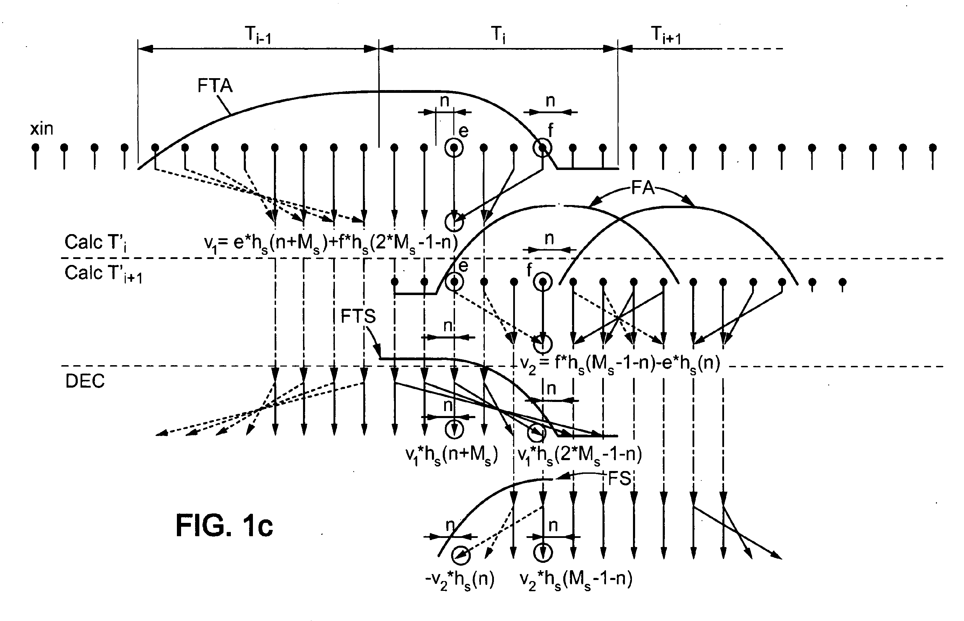

La figure 1 illustre schématiquement la structure d'un codeur par transformée, avec :

- un banc BA de filtres d'analyse FAI, ..., FAn, attaquant le signal d'entrée X,
- un module de quantification Q, suivi d'un module de codage COD,
- et un banc BS de filtres de synthèse FSI, ..., FSn délivrant le signal codé X'.

Pour réduire encore le débit avant transmission, les échantillons fréquentiels quantifiés sont codés, souvent à l'aide d'un codage dit « entropique » (codage sans perte). La quantification est réalisée de façon classique par un quantificateur scalaire, uniforme ou non, ou encore par un quantificateur vectoriel.

Le bruit introduit dans l'étape de quantification est mis en forme par le banc de filtres de synthèse (appelé également « transformation inverse »). La transformation inverse, liée à la transformée d'analyse, doit donc être choisie afin de bien concentrer le bruit de quantification, fréquentiellement ou temporellement, afin d'éviter qu'il ne devienne audible.

La transformation d'analyse doit concentrer au mieux l'énergie du signal afin de permettre un codage aisé des échantillons dans le domaine transformé. En particulier, le gain de codage de la transformée, qui dépend du signal d'entrée, doit être maximisé dans la mesure du possible. On utilise à cet effet une relation du type :

$$SNR = G_{TC} + K \cdot R$$

où $K$ est un terme constant qui peut avantageusement valoir 6,02.

Ainsi, le rapport signal à bruit obtenu ($SNR$) est proportionnel au nombre de bits par échantillon sélectionné (R) augmenté de la composante $G_{TC}$ qui représente le gain de codage de la transformée. Plus le gain de codage est important et plus la qualité de reconstruction est bonne.

On comprend donc l'importance que revêt la transformation en codage. Elle assure un codage aisé des échantillons, grâce à son aptitude à concentrer à la fois l'énergie du signal (par la partie analyse) et le bruit de quantification (par la partie synthèse).

Les signaux audio étant notoirement non stationnaires, il convient d'adapter la transformation temps fréquence au cours du temps, en fonction de la nature du signal audio.

On décrit ci-après quelques applications à des techniques de codage usuelles.

Dans le cas de transformées modulées, les techniques de codage audio normalisées intègrent des bancs de filtres modulés en cosinus qui permettent de mettre en oeuvre ces techniques de codage à l'aide d'algorithmes rapides, basés sur des transformées en cosinus ou des transformées de Fourier rapides.

Parmi les transformées de ce type, la transformée la plus communément utilisée (en codage MP3, MPEG-2 et MPEG-4 AAC en particulier) est la transformée MDCT (« *Modified Discrete Cosine Transform* ») dont l'expression est présentée ci-dessous :

$$X_k^t = \sum_{n=0}^{2M-1} x_{n+tM}\, p_k(n)\ 0 \le k < M$$

avec les notations suivantes :

- $M$ représente la taille de la transformée.

- $x_{n+tM}$ sont les échantillons du son numérisé à une période $\dfrac{1}{F_e}$ (inverse de la fréquence d'échantillonnage) à l'instant $n + tM$,

- $t$ est l'indice de trame.

- $X_k^t$ sont les échantillons dans le domaine transformé pour la trame t,

- $p_k(n) = \sqrt{\dfrac{2}{M}} h(n) \cos\left[\dfrac{\pi}{4M}(2n+1+M)(2k+1)\right]$ est une fonction de base de la transformée dont $h(n)$ est appelé filtre prototype de taille 2M .

Pour restituer les échantillons temporels initiaux, la transformation inverse suivante est appliquée afin de reconstituer les échantillons $0 \leq n \leq M - 1$:

$$\hat{x}_{n+tM} = \sum_{k=0}^{M-1}\left[ X_k^{t+1} p_k(n) + X_k^t p_k(n+M)\right]$$

En référence à la figure la, la reconstruction s'effectue comme suit :

- transformée DCT inverse (notée ci-après DCT$^{-1}$) des échantillons $X_k^t$ donnant 2M échantillons,

- transformée DCT inverse des échantillons $X_k^{t+1}$ donnant 2M échantillons, les M premiers échantillons ayant un support temporel identique aux M derniers échantillons de la trame précédente,

- pondération par la fenêtre de synthèse h(M+n) pour la deuxième moitié de la trame $T_i$ (M derniers échantillons), et par la fenêtre de synthèse h(n) pour la première moitié de la trame suivante $T_{i+1}$ (M premiers échantillons), et

- additions des composantes fenêtrées sur le support commun.

Afin d'assurer la reconstruction exacte (dite « parfaite ») du signal (selon la condition $\hat{x}_{n+tM} = x_{n+tM}$), il convient de choisir une fenêtre prototype $h(n)$ satisfaisant quelques contraintes.

Typiquement, les relations suivantes sont satisfaisantes afin de permettre une reconstruction parfaite :

$$\begin{cases} h(2M-1-n) = h(n) \\ h^2(n) + h^2(n+M) = 1 \end{cases} \qquad (1)$$

les fenêtres étant à symétrie paire par rapport à un échantillon central.

Il est relativement simple de satisfaire ces deux contraintes simples et, à cet effet, un filtre prototype classique est constitué d'une fenêtre sinusoïdale qui s'écrit comme suit :

$$h(n) = \sin\left[\dfrac{\pi}{2M}(n+0.5)\right]$$

Bien entendu, d'autres formes de filtre prototype existent, telles que les fenêtres définies dans la norme MPEG-4 sous le nom de « Kaiser Bessel Dérivées » (ou KBD), ou encore les fenêtres à faible recouvrement (pour « Low Overlap »).

Un exemple de traitement par une transformée MDCT, avec fenêtres longues, est donné sur la figure la. Sur cette figure :

- les flèches en traits pointillés illustrent une soustraction,

- les flèches en traits pleins illustrent une addition,
- les flèches en traits pointillés mixtes illustrent un traitement DCT au codage et DCT$^{-1}$ au décodage DEC, ce terme DCT correspondant au terme en cosinus de la fonction de base présentée ci-avant,
- les échantillons du signal à coder sont dans un flux noté xin, et on suit l'évolution des traitements de codage/décodage de certains échantillons entourés et référencés a et b sur la figure 1b et e et f sur la figure 1c,
- les échantillons xin sont regroupés par trames, une trame courante est notée $T_i$, les trames précédente et suivante étant notées respectivement $T_{i-1}$ et $T_{i+1}$,
- la référence DEC est propre au traitement réalisé par le décodeur (utilisant des fenêtres de synthèse FS avec addition-recouvrement),
- les fenêtres d'analyse sont notées FA et les fenêtres de synthèse sont notées FS,
- n est la distance entre le milieu de fenêtre et l'échantillon a.

La référence calc T'$_i$ est propre au calcul de la trame codée T'$_i$ utilisant la fenêtre d'analyse FA et les échantillons respectifs des trames $T_{i-1}$ et $T_i$. Il s'agit simplement ici d'un exemple de convention illustré sur la figure 1a. Il pourrait aussi être décidé, par exemple, d'indexer les trames $T_i$ et $T_{i+1}$ pour le calcul d'une trame codée T'$_i$. En poursuivant l'exemple de la figure 1a, la référence calc T'$_{i+1}$ est propre au calcul de la trame codée T'$_{i+1}$ en utilisant les échantillons respectifs des trames $T_i$ et $T_{i+1}$.

Les termes v1 et v2 obtenus avant transformation DCT et transformation inverse DCT$^{-1}$ sont obtenus avec des équations du type :

$$v1 = a*h(M+n) + b*h(2*M-1-n),$$

et

$$v2 = b*h(M-1-n) - a*h(n)$$

Ainsi, après traitement global DCT/DCT$^{-1}$ et fenêtre de synthèse, les termes de reconstruction a' et b' s'écrivent:

$$a' = v1 * h(M+n) - v2 * h(n) =$$

$$a*h(M+n)* h(M+n) + b*h(2*M-1-n)* h(M+n) - b*h(M-1-n)* h(n) + a*h(n)* h(n),$$

et

$$b' = v1 * h(2*M-1-n) + v2 * h(M-1-n) =$$

$$a*h(M+n)*\ h(2M-n-1)\ +\ b*h(2*M-1-n-1)*\ h(2M-n-1)\ +\ b*h(M-1-n)*\ h(M-1-n)\ -$$

$$a*h(n)*\ h(M-1-n)$$

et l'on vérifie bien alors que la reconstruction est parfaite (a'=a et b'=b).
(en utilisant les relations (1) et en en déduisant h(M-1-n)=h(n+M))

Le principe décrit ci-avant d'une transformée MDCT s'étend naturellement à des transformées nommées ELT (« Extended Lapped Transform »), dans lesquelles l'ordre des fonctions de base est plus grand que deux fois la taille de la transformée, avec en particulier : $X_k^t = \sum_{n=0}^{L-1} x_{n+tM}\, p_k(n)$, où $0 \le k < M$ et $L = 2KM$, *K étant* un entier positif supérieur à 2.

Pour la reconstruction, au lieu d'associer deux trames consécutives comme pour une transformée MDCT, la synthèse des échantillons met en oeuvre *K* trames successives fenêtrées.

On indique en outre que la contrainte de symétrie des fenêtres (principe décrit en détail ci-après) peut être relâchée pour une transformée de type ELT. La contrainte d'identité entre les fenêtres d'analyse et de synthèse peut également être relâchée et on parle alors de filtres bi-orthogonaux.

Compte tenu de la nécessité d'adapter la transformée au signal à coder, les techniques antérieures comme celle proposée par Omar Niamut et AP. in "RD Optimal Time Segmentation For The Time-Varying MOCT,"EURASSIP, autorisent ce qui est appelé une « commutation de fenêtre », c'est-à-dire un changement au cours du temps de la taille de la transformée utilisée.

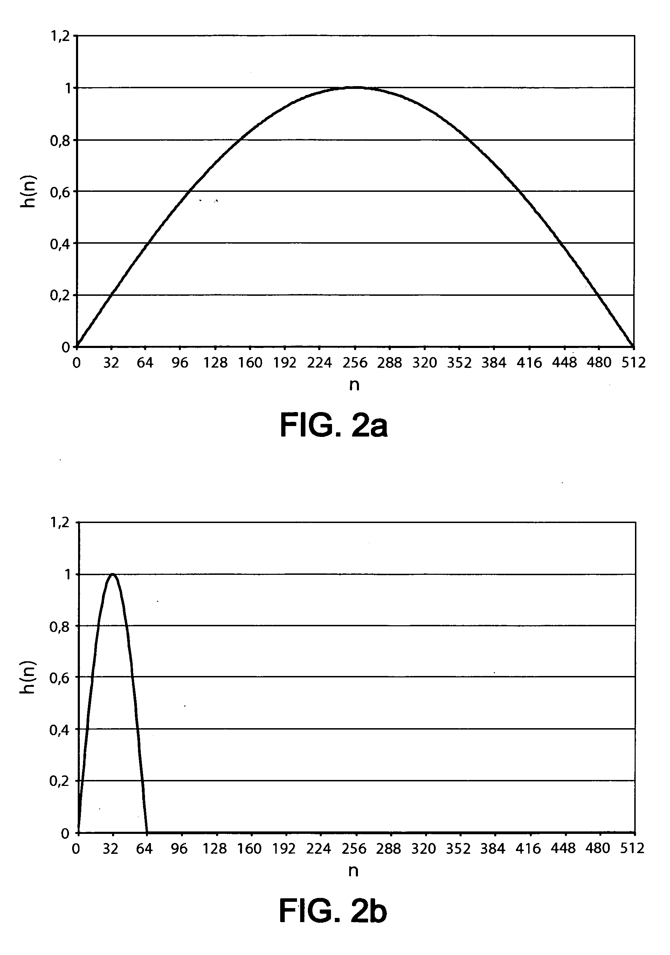

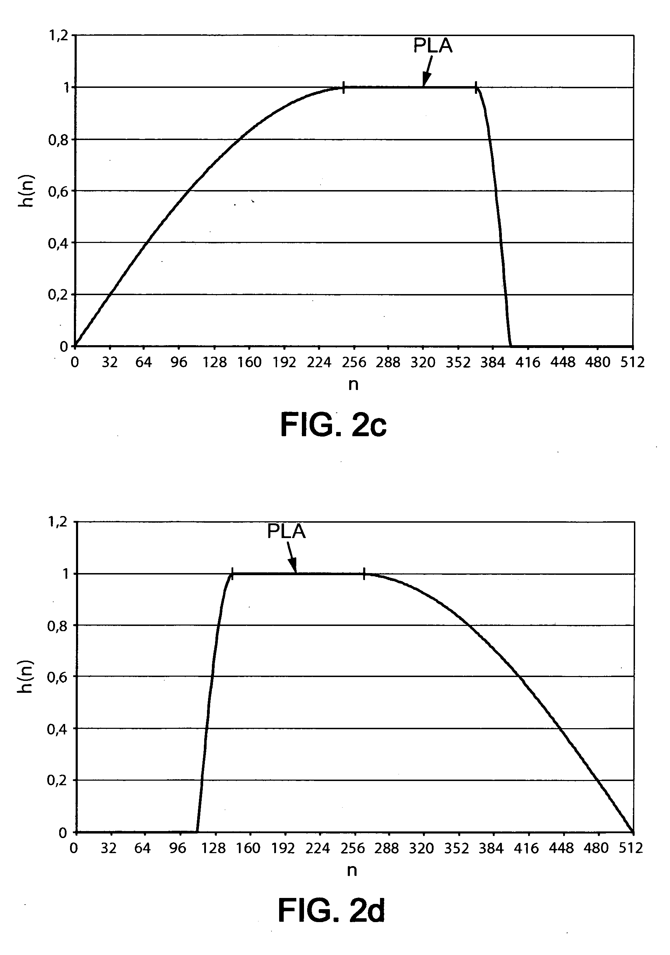

La nécessité de changer de longueur de fenêtre peut se justifier notamment dans le cas suivant. Lorsque le signal à coder, par exemple un signal de parole, comporte un signal transitoire (non stationnaire) caractérisant une attaque forte (par exemple la prononciation d'un son « ta » ou « pa » caractérisant une plosive dans le signal de parole), il convient d'augmenter la résolution temporelle du codage et de là, de diminuer la taille des fenêtres de codage, ce qui nécessite donc de passer d'une fenêtre longue à une fenêtre courte. Très exactement, dans l'art antérieur connu, on passe dans ce cas d'une fenêtre longue (figure 2a qui sera décrite plus loin) à une fenêtre de transition (figure 2c décrite plus loin), puis à une série de fenêtres courtes (figure 2b décrite plus loin). Il faut donc anticiper une attaque sur au moins une trame suivante, comme on le verra en détail plus loin, avant de pouvoir décider la longueur de la fenêtre de codage d'une trame courante, et, par conséquent, coder la trame courante.

On décrit ci-après un exemple de changement de longueur de fenêtre au sens de l'art antérieur.

Un exemple typique est le changement de taille d'une transformée MDCT de taille *M* vers une taille *M* /8, comme prévu dans la norme MPEG-AAC.

Afin de conserver la propriété de reconstruction parfaite, l'équation (1) ci-avant doit être remplacée par les formulations suivantes au moment de la transition entre deux tailles :

$$\begin{cases} h^2(n) + h^2(M-n) = 1 & \text{pour} \quad 0 \le n < M \\ h^2(M+n) + h^2(2M-n) = 1 & \text{sinon} \end{cases}$$

Une relation est donnée en outre pour les filtres prototypes consécutifs de tailles différentes :

$$h_1(M + M/2 - M_s/2 + n) = h_2(M_s - n) \quad 0 \le n < M_s$$

Il existe donc une symétrie autour de la taille *M* /2 au moment de la transition.

On a illustré différents types de fenêtre sur les figures 2a à 2e, avec respectivement :

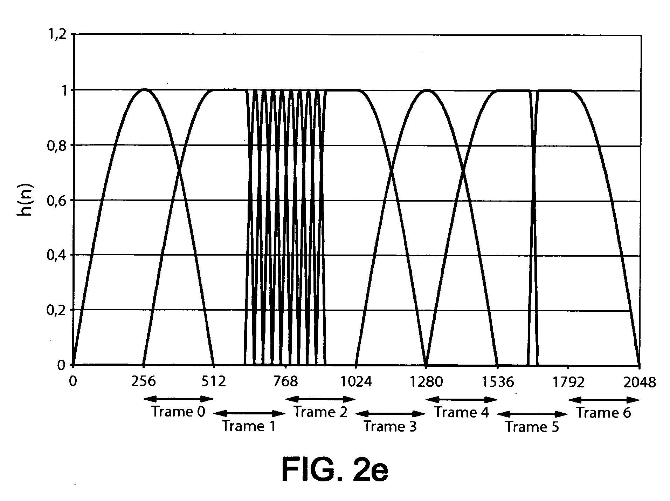

- une fenêtre sinusoïdale (fonction symétrique sinus) de taille 2M=512 échantillons pour la figure 2a,
- une fenêtre sinusoïdale (fonction symétrique sinus) de taille 2Ms=64 échantillons pour la figure 2b,
- une fenêtre de transition permettant de passer d'une taille 512 à 64 pour la figure 2c,
- une fenêtre de transition permettant de passer d'une taille de 64 à 512 pour la figure 2d,
- et un exemple de construction effectuée à l'aide des fenêtres de base présentées plus haut, pour la figure 2e.

Chaque succession est de « longueur » prédéterminée définissant ce qui est appelé « la longueur de fenêtre ». Ainsi, des échantillons à coder sont combinés, au moins deux à deux, et pondérés, dans la combinaison, par des valeurs respectives de pondération de la fenêtre, comme on l'a vu en référence à la figure 1a.

Plus particulièrement, les fenêtres sinusoïdales (figures 2a et 2b) sont symétriques, c'est-à-dire que les valeurs de pondération sont sensiblement égales de part et d'autre d'une valeur centrale, au milieu de la succession de valeurs formant la fenêtre. Une réalisation avantageuse consiste à choisir des fonctions « sinus » pour définir les variations de valeurs de pondération de ces fenêtres. Les autres choix de fenêtre restant possible (par exemple ceux utilisés dans les codeurs MPEG AAC).

On relèvera au contraire que les fenêtres de transition (figures 2c et 2d) sont asymétriques et comportent une région « plate » (référence PLA), ce qui signifie que les valeurs de pondération dans ces régions sont maximales et par exemple sont égales à « 1 ». Comme on le verra en référence aux figures 1b et 1c, en utilisant une fenêtre de transition d'une fenêtre longue à une fenêtre courte (figure 2c), deux échantillons (dans l'exemple représenté sur la figure 1b), dont l'échantillon a, sont simplement pondérés par un facteur « 1 », tandis que l'échantillon b est pondéré par le facteur « 0 » dans le calcul de la trame codée T'$_i$, de sorte que les deux échantillons dont l'échantillon a sont simplement transmis tels quels (la DCT mise à part) dans la trame codée T'$_i$.

On décrit ci-après l'utilisation d'une transformée à taille variable dans un système de codage. On décrit aussi les opérations au niveau d'un décodeur qui doit reconstituer les échantillons audio.

Dans les systèmes normalisés, le codeur sélectionne le plus souvent la transformée à utiliser au cours du temps. Ainsi, dans la norme AAC, le codeur transmet deux bits permettant de sélectionner l'une des quatre configurations de taille de fenêtre présentées ci-dessus.

Le traitement par transformée MDCT utilisant les fenêtres de transition (longue - courte) est illustré sur les figures 1b et 1c. Ces figures représentent les calculs menés, de la même manière que pour la figure 1a.

Sur les figures 1b et 1c, on a représenté seulement quelques fenêtres courtes, d'analyse, référencées FA (avec Ms=M/2 dans l'exemple illustré). Néanmoins, en réalité, comme illustré sur la figure 2e, on prévoit une succession de plusieurs fenêtres courtes (avec typiquement Ms=M/8). On comprendra donc que chaque fenêtre FA des figures 1b et 1c englobe en réalité une succession de fenêtres courtes.

La fenêtre de transition FTA (figure 1b), pour le calcul de la trame codée T'$_i$ (référence calc T'$_i$) comporte :

- une demi-fenêtre longue sur M échantillons, dans son front montant, et,
- dans son front descendant :

    o une première région plate PLA (avec des valeurs de pondération égales à 1) sur (M/2-Ms/2) échantillons,
    o une demi-fenêtre courte descendante sur Ms échantillons, et
    o une seconde région plate (avec des valeurs de pondération égales à 0) sur (M/2-Ms/2) échantillons.

Pour le calcul de la trame codée suivante T'$_{i+1}$ (référence calc T'$_{i+1}$), les (M/2-Ms/2) premiers échantillons sont ignorés et donc non traités par les fenêtres courtes, les Ms échantillons suivants sont pondérés par le front montant de la fenêtre courte d'analyse FA telle qu'illustrée sur les figures 1b et 1c, et les Ms échantillons suivants sont pondérés par son front descendant.

Dans ce qui suit, les notations suivantes sont utilisées :

- M est la taille de trame longue,
- M$_s$ est la taille de trame courte.

Sur la figure 1b, l'échantillon b est synthétisé en utilisant uniquement les fenêtres courtes pour respecter l'analogie avec le calcul pour les fenêtres longues. Ensuite, du fait de la forme particulière de la demi-fenêtre de transition longue-courte, l'échantillon a est reconstruit directement à partir des fenêtres de transition d'analyse et de synthèse. La fenêtre de transition est référencée FTA sur les figures 1b et 1c.

Sur la figure 1c, les échantillons correspondant à la zone de transition entre la fenêtre longue-courte et la fenêtre courte sont calculés. Par analogie avec le calcul pour les fenêtres longues de la figure 1a, on suit ici le traitement des échantillons notés e et f (entourés).

Deux exemples de situation de transition de fenêtres sont décrits ci-après.

Dans un premier exemple, on a détecté une attaque nécessitant l'utilisation de fenêtres courtes dans le signal audio à un instant t=720 (figure 2e). Le codeur doit signifier au décodeur l'utilisation de fenêtres de transition long-court venant s'interposer entre les fenêtres longues utilisées préalablement et les fenêtres courtes, ultérieures.

Ainsi, le codeur indique au décodeur, successivement, les séquences :

• fenêtre longue
• fenêtre de transition long-court
• fenêtre courte
• fenêtre de transition court-long
• fenêtre longue.

Le décodeur applique alors une relation du type :

$$\hat{x}_{n+tM} = \sum_{k=0}^{M-1} \Big[ X_k^{t+1} p^l_k(n) + X_k^t p^s_k(n+M) \Big]$$

où $p^l_k$ et $p^s_k$ représentent les fonctions de synthèse des transformées aux temps t et t+1, qui peuvent être distinctes l'une de l'autre.

La reconstruction se fait comme précédemment, à la différence près que si les fonctions de base $p_k^l$ et $p_k^s$ sont de « tailles » différentes, alors on effectue, en référence à la figure 1b :

- une transformée DCT inverse de taille M des échantillons $X_k^t$ donnant 2M échantillons,

- une transformée DCT inverse de taille Ms des échantillons $X_k^{t+1}$ donnant 2Ms échantillons, les Ms premiers échantillons ayant un support temporel commun de longueur Ms dans une zone de recouvrement comportant la partie montante de la fenêtre courte, avec les échantillons issus de la transformée DCT inverse de taille M de la partie descendante de la fenêtre de transition FTA,

- une multiplication par la fenêtre de synthèse duale de la fenêtre de transition FTA et référencée FTS sur la figure 1b, pour la première moitié, et une multiplication par la fenêtre de synthèse courte FS pour la seconde moitié, et

- les additions de ces composantes fenêtrées sur la zone de recouvrement, le support temporel correspondant à une partie de fin de la trame initiale T$_i$.

Le décodeur est donc esclave du codeur et applique fidèlement les types de fenêtre décidés par le codeur.

Dans ce premier exemple, le codeur détecte une transition lors de l'arrivée des échantillons d'une première trame (par exemple la trame 1 de la figure 2e, comportant les échantillons entre les instants t=512 et t=767). Le codeur peut alors décider que la fenêtre courante doit être une fenêtre de transition long-court, encodée, transmise et signalée au décodeur. Ensuite, huit fenêtres courtes sont successivement appliquées entre les échantillons t=624 et t=911. Ainsi, au moment de la transition (t=720), l'encodeur utilise les fenêtres courtes, ce qui permet une meilleure représentation temporelle du signal.

Dans un deuxième exemple, une transition est détectée à l'échantillon t=540. Lorsque le codeur reçoit les échantillons d'une première trame (la trame 0 de la figure 2e par exemple), il ne détecte pas de transition et sélectionne donc une fenêtre longue. Lors de l'arrivée des échantillons d'une seconde trame (trame 1 dans l'exemple de la figure 2e), suivante, le codeur détecte une attaque (à l'instant t=540). Dans ce cas alors, la détection est effectuée trop tardivement et l'utilisation d'une fenêtre de transition ne permet pas de bénéficier de l'utilisation des supports temporels courts (fenêtres courtes) au moment de l'attaque. Le codeur doit alors anticiper l'utilisation de fenêtres courtes et, par conséquent, insérer un délai de codage additionnel correspondant à au moins M/2 échantillons.

On comprendra alors qu'un inconvénient de l'art antérieur connu réside dans le fait qu'il est nécessaire d'introduire un retard supplémentaire à l'encodeur pour permettre de détecter une attaque dans le signal temporel d'une trame suivante et d'anticiper alors le passage aux fenêtres courtes. Cette « attaque » peut correspondre à un signal transitoire de forte intensité, tel qu'une plosive, par exemple, dans un signal de parole, ou encore à l'apparition d'un signal percussif dans une séquence musicale.

Dans certaines applications de télécommunications, le retard supplémentaire, nécessaire pour la détection de signaux transitoires et l'utilisation des fenêtres de transition, n'est pas acceptable. Ainsi par exemple, dans le codeur MPEG-4 AAC « Low Delay » (à faible retard), les fenêtres courtes ne sont pas utilisées, seules les fenêtres longues étant permises.

La présente invention vient améliorer la situation.

Elle propose une transition entre fenêtres ne nécessitant pas l'introduction d'un retard supplémentaire.

Elle vise à cet effet un procédé de décodage, par transformée, un décodeur par transformée et un programme informatique, destiné à être stocké en mémoire d'un codeur par transformé , d'un signal audionumérique représenté par une succession de trames,
dans lequel :

- on prévoit au moins deux fenêtres de pondération, de longueurs respectives distinctes, et
- on utilise une fenêtre courte pour coder une trame dans laquelle un événement particulier a été détecté.

Cet événement particulier peut être par exemple un phénomène non stationnaire, tel qu'une attaque forte présente dans le signal audionumérique que contient la trame courante.

Plus particulièrement, pour le codage d'une trame courante, on cherche à détecter l'événement particulier dans cette trame courante, et :

- au moins si l'événement particulier est détecté en début de la trame courante, on applique une fenêtre courte pour coder la trame courante,

- tandis que si l'événement particulier n'est pas détecté dans la trame courante, on applique une fenêtre longue pour coder la trame courante.

On réitère ces étapes pour une trame suivante, de sorte qu'il est possible, au sens de l'invention, de coder une trame donnée en utilisant une fenêtre longue et de coder une trame qui suit immédiatement cette trame donnée en utilisant directement ensuite une fenêtre courte, sans utiliser de fenêtre de transition comme dans l'art antérieur.

En s'offrant la possibilité de passer directement d'une fenêtre longue à une fenêtre courte, la détection de l'événement particulier peut être menée directement sur la trame en cours de codage et non plus sur la trame suivante, comme dans l'art antérieur. Dès lors, un codage réalisé par le procédé au sens de l'invention est effectué sans retard supplémentaire par rapport à une transformée MDCT de taille fixe, contrairement aux codages défait antérieur.

D'autres caractéristiques et avantages de l'invention apparaîtront à l'examen de la description détaillée ci-après, et des dessins annexés sur lesquels, outre les figures 1, 1a, 1b, 1c, 2a, 2b, 2c, 2d, 2e, relatives à l'art antérieur et décrites ci-avant :

- la figure 3a illustre schématiquement un traitement de codage/décodage au sens de l'invention en suivant l'évolution d'échantillons a et b, comme sur la figure 1b décrite précédemment,
- la figure 3b illustre schématiquement un traitement de codage/décodage au sens de l'invention en suivant l'évolution d'échantillons e et f, comme sur la figure 1c décrite précédemment, et
- les figures 4a et 4b illustrent des exemples de variation des fonctions de pondération utilisées pour la compensation au décodage, menée dans la mise en oeuvre de l'invention,
- la figure 5a illustre un exemple de traitement qui peut être appliqué dans un codeur au sens de l'invention,
- la figure 5b illustre un exemple de traitement qui peut être appliqué dans un décodeur au sens de l'invention, et
- la figure 6 illustre les structures respectives d'un codeur et d'un décodeur et la communication de l'information du type de fenêtre utilisée au codage,
- la figure 7 illustre une fenêtre de synthèse longue pour le cas d'une transformée ELT à M=512 composantes et un coefficient de recouvrement K=4,
- la figure 8 représente l'allure des fonctions de pondération $w_{1,n}$ et $w_{2,n}$ (pour n compris entre 0 et M/2-Ms/2) dans un mode de réalisation où l'on tient compte de l'influence des échantillons passés dans un contexte de codage avec recouvrement,
- la figure 9 représente l'allure des fonctions de pondération $w'_{1,n}$ et $w'_{2,n}$ (pour n compris entre M/2-Ms/2 et M/2+Ms/2) dans ce mode de réalisation,
- la figure 10 représente l'allure des fonctions de pondération $w'_{3,n}$ et $w'_{4,n}$ (pour n compris entre M/2-Ms/2 et M/2+Ms/2) dans ce mode de réalisation,
- la figure 11 représente l'allure des fonctions de pondération $w_{1,n}$ et $w_{2,n}$ sur toute la plage de n comprise entre 0 et M/2+Ms/2 dans une variante du mode de réalisation illustré sur la figure 8,
- la figure 12 représente l'allure des fonctions de pondération $w_{3,n}$ et $w_{4,n}$ sur toute la plage de n comprise entre 0 et M/2+Ms/2 dans cette variante.

La présente invention permet d'éviter d'appliquer des fenêtres de transition au moins pour le passage d'une fenêtre longue à une fenêtre courte.

Ainsi, en reprenant le deuxième exemple décrit précédemment en référence à la figure 2e, si un phénomène non stationnaire ou « attaque » est détecté à l'instant t=540, la présente invention propose d'utiliser une fenêtre longue pour la trame 0 (fenêtre s'étendant de l'instant t=256 à l'instant t=511). Ensuite, lors de l'acquisition des échantillons de la trame suivante (t=512 à t=767) et de la détection d'une attaque à t=540, le codeur utilise huit fenêtres courtes pour encoder les échantillons à partir de l'instant t=368 (correspondant à t=512-M/2-$M_s$/2), jusqu'à l'instant t=655 (correspondant à t=512+M/2+$M_s$/2-1, où

- 2*M=512 est la taille de la fenêtre longue, et
- 2*$M_s$=64 est la taille de la fenêtre courte, dans l'exemple décrit),

et ce, sans fenêtre de transition classique, asymétrique comme celle représentée sur les figures 1b et 1c relatives à l'art antérieur.

Au niveau du décodeur, lors de la réception de la trame encodée avec des fenêtres courtes, le décodeur procède alors aux opérations suivantes :

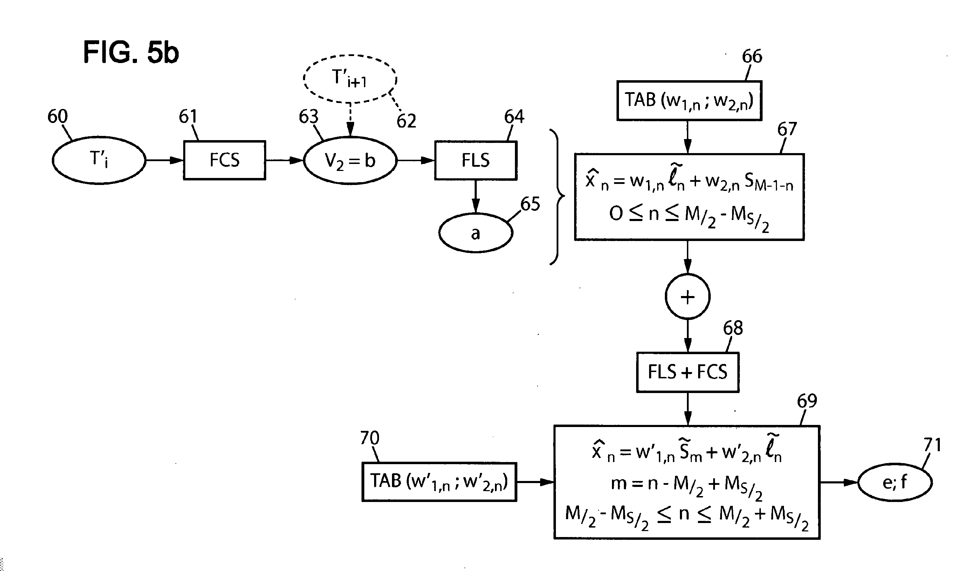

• réception d'une information issue du codeur indiquant que des fenêtres courtes doivent être utilisées pour la trame courante,
• application d'un traitement avantageux pour compenser la transition directe d'une fenêtre longue à une fenêtre courte au codage, un exemple de ce traitement étant décrit en détail plus loin, en référence à la figure 5b.

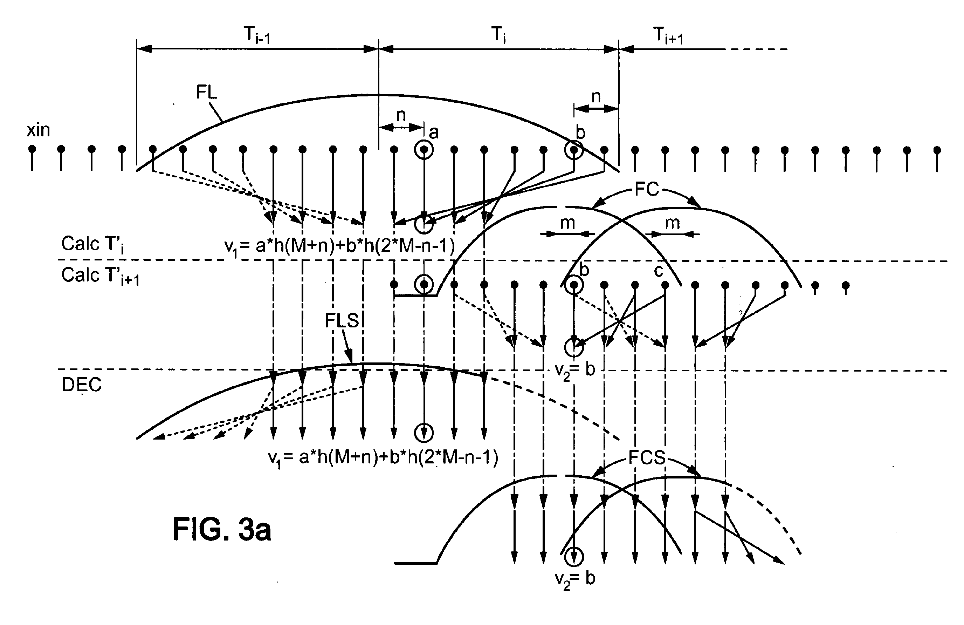

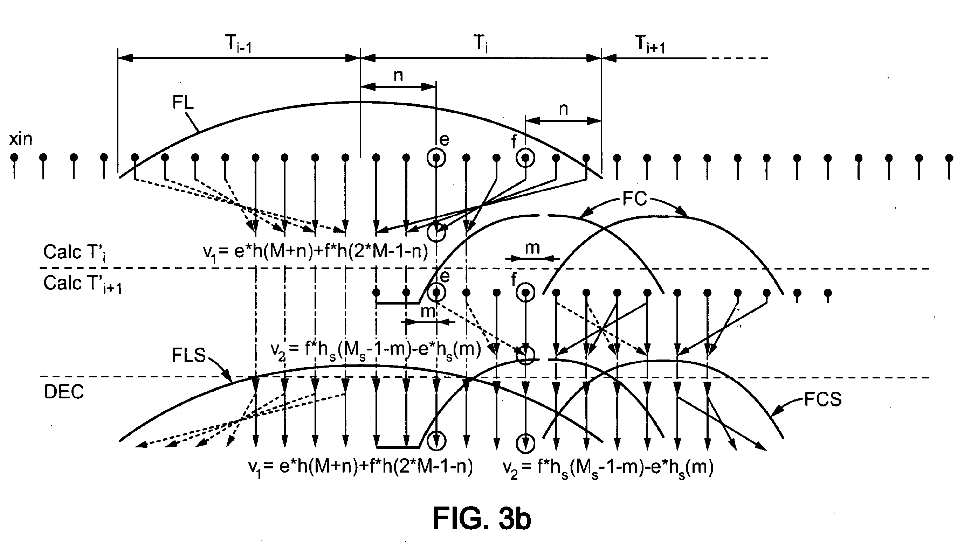

Les figures 3a et 3b illustrent le procédé de codage/décodage au sens de l'invention pour obtenir d'une part les échantillons a et b qui se trouvent dans une zone sans recouvrement entre les fenêtres longues et courtes (figure 3a), et d'autre part les échantillons e et f se trouvant dans cette zone de recouvrement (figure 3b). En particulier, cette zone de recouvrement est définie par le front descendant de la fenêtre longue FL et le front montant de la première fenêtre courte FC.

Ainsi, en référence aux figures 3a et 3b, au codage, les échantillons des trames $T_{i-1}$ et $T_i$ sont pondérés par la fenêtre longue d'analyse FL pour constituer la trame codée $T'_i$ et les échantillons de la trame suivante $T_i$ et $T_{i+1}$ sont pondérés directement par des fenêtres d'analyse courtes FC, sans appliquer de fenêtre de transition.

On remarquera aussi, en référence aux figures 3a et 3b, que la première fenêtre courte d'analyse FC est précédée par des valeurs non prises en compte par les fenêtres courtes (pour les échantillons précédant l'échantillon e dans l'exemple de la figure 3b). Plus particulièrement, ce traitement s'applique aux M/2-Ms/2 premiers échantillons de la trame à coder $T'_{i+1}$, et ce, de façon analogue aux codeurs/décodeurs de l'art antérieur. De manière générale, on cherche à perturber le moins possible les traitements réalisés au codage, comme au décodage, par rapport à l'art antérieur. C'est ainsi qu'il est choisi par exemple d'ignorer les premiers échantillons de la trame codée $T'_{i+1}$.

Bien entendu, sur les figures 3a et 3b, on a représenté uniquement le cas de deux fenêtres courtes (Ms = M/2) d'analyse FC. Néanmoins, on prévoit, comme dans l'art antérieur, une succession de plusieurs fenêtres courtes et chaque succession de fenêtres courtes est illustré sur ces figures 3a et 3b en portant la référence FC.

Dans ce qui suit, on décrit deux exemples de réalisation pour décoder une trame $T'_{i+1}$ qui a été codée en utilisant une fenêtre courte FC alors qu'une trame immédiatement précédente $T'_i$ avait été codée en utilisant une fenêtre longue FL.

Dans une première forme de réalisation, on s'affranchit complètement de l'utilisation de fenêtres de synthèse au décodage et l'on démontre que la propriété de reconstruction parfaite est assurée.

Sur la figure 3a, lors de la détection d'une attaque nécessitant un changement de fenêtre (d'une fenêtre longue directement à une fenêtre courte), on synthétise tout d'abord les échantillons à partir des fenêtres courtes uniquement (échantillon b sur la figure 3a). Puis, on compense dans la valeur v1 calculée à partir de la fenêtre longue d'analyse l'effet de l'échantillon b calculé au préalable. Le calcul de codage (trame codée $T'_i$) pour l'échantillon a s'effectue alors comme suit :

$$v1 = a*h(M+n) + b*h(2*M-1-n).$$

En revanche, l'échantillon a n'est pas pondéré dans la valeur de codage v2 puisque le calcul de pondération à partir de la fenêtre courte suivie d'une combinaison s'effectue sur un support temporel distinct (trame codée $T'_{i+1}$), et on a après reconstruction à partir des fenêtres courtes :

$$v2 = b$$

On vérifie avantageusement la reconstruction parfaite dans le codage/décodage au sens de l'invention. En effet :

$$a' = (v1 - v2 * h(2*M-1-n))/ h(M+n) = a$$

On remarquera aussi, au décodage, que les échantillons tirés des valeurs v2=b et les suivants doivent être déterminés en premier, avant la détermination des échantillons du début de la trame (comme l'échantillon a). On procède donc à un renversement temporel lors du décodage.

Sur la figure 3b, on calcule les échantillons codés de la zone de transition entre la fenêtre longue FL (front descendant) et la première fenêtre courte FC (front montant), au niveau donc des échantillons e et f. L'expression des coefficients codés (ou « valeurs v1 et v2 » ci-après) est donnée, dans cette zone de recouvrement entre les deux fenêtres FL et FC, par les équations suivantes :

$$v1 = e*h(M+n) + f*h(2*M-1-n),$$

et

$$v2 = f*h_s(M_s-1-m) - e*h_s(m)$$

Au décodeur, on doit donc résoudre ce système d'équations à deux inconnues pour retrouver les valeurs des échantillons e et f :

$$e=[v1 * h_s(M_s-1-m)-v2*h(2*M-1-n)]/[h(M+n)*h_s(M_s-1-m)+h_s(m)*h(2*M-1-n)]$$

$$f = [v1*h_s(m) + v2*h(M+n)]/[ h_s(M_s-1-m)*h(M+n) + h(2*M-1-n) *h_s(m)]$$

On en déduit encore les formules vérifiant avantageusement la propriété de reconstruction parfaite :

$$e'= [v1*h_s(M_s+m) - v2*h(n)] / [h(M+n)*h_s(M_s+m) + h(2*M-1-n)*h_s(m)] = e,$$

et

$$f'= [v1*h_s(2*M_s-1-m) + v2*h(M-1-n)] / [h(M+n)*h_s(M_s+m) + h(2*M-1-n)*h_s(m)] = f,$$

$$\text{avec } m = n - M/2 +M_s/2$$

On relèvera que la valeur v2 est pondérée par la fenêtre longue h, et ce, contrairement à ce qui était établi dans l'art antérieur (où v2 était pondérée par la fenêtre courte $h_s$ comme le montre le bas de la figure 1c).

Dans une seconde forme de réalisation, on conserve des fenêtres de synthèse au décodage. Elles sont de même forme que les fenêtres d'analyse (homologues ou duales des fenêtres d'analyse), telles qu'illustrées sur les figures 3a et 3b et portant la référence FLS pour une fenêtre longue, de synthèse, et la référence FCS pour une fenêtre courte, de synthèse. Cette seconde forme de réalisation présente l'avantage d'être conforme au fonctionnement des décodeurs de l'état de l'art, à savoir utiliser une fenêtre de synthèse longue pour décoder une trame qui a été codée avec une fenêtre d'analyse longue et utiliser une série de fenêtres de synthèse courtes pour décoder une trame qui a été codée avec une série de fenêtres d'analyse courtes.

En revanche, on applique une correction de ces fenêtres de synthèse, par « compensation », pour décoder une trame qui a été codée avec une fenêtre longue, alors qu'elle aurait dû être codée avec une fenêtre de transition long-court. En d'autres termes, pour compenser l'effet du passage direct d'une fenêtre longue à une fenêtre courte, au codeur, on réalise le traitement ci-après pour décoder une trame courante $T'_{i+1}$ qui a été codée en utilisant une fenêtre courte FC tandis qu'une trame immédiatement précédente $T'_i$ avait été codée en utilisant une fenêtre longue FL.

Les équations données ci-dessus pour le décodage et liant les échantillons a, b, e, f aux valeurs v1 et v2, peuvent être réécrites sous la forme de sommes pondérées de deux termes, comme suit, en procédant en particulier à un renversement temporel.

D'abord, on se place dans les premières fenêtres courtes de synthèse FCS et après la zone de recouvrement précitée (typiquement à l'échantillon $v_2$=b et les suivants dans l'illustration à titre explicatif de la figure 3a). Pour le décodage de cette partie sans recouvrement, à partir de fenêtres de synthèse courtes FCS uniquement, on décode d'abord les « valeurs » de la trame codée $T'_{i+1}$ à partir de $v_2$=b (figure 3a). Une fois que les échantillons b et les suivants sont décodés, on applique la somme pondérée de deux termes suivante :

$$\hat{x}_n = w_{1,n}\tilde{l}_n + w_{2,n}s_{M-1-n}, \text{ avec } 0 \le n < M/2 - Ms/2, \text{ où :}$$

où :

- $\hat{x}_n$ représente les échantillons décodés (correspondant aux échantillons initiaux $x_n$, puisque le codage/décodage est à reconstruction parfaite),
- la notation $\tilde{l}_n$ désigne ce qui correspondrait à des échantillons qui auraient été décodés (application d'une transformation inverse DCT$^{-1}$) en utilisant une fenêtre de synthèse longue FLS, sans correction, et
- $s_n$ représente les échantillons complètement décodés (typiquement l'échantillon b et les échantillons qui le suivent) à l'aide de la succession de fenêtres courtes de synthèse FCS.

Les deux fonctions de pondération $w_{1,n}$ et $w_{2,n}$ s'écrivent alors :

$$w_{1,n} = \frac{1}{h^2(M+n)} \text{ et } w_{2,n} = -\frac{h(2M-n-1)}{h(M+n)} = -\frac{h(n)}{h(M+n)}, \text{ avec } 0 \le n < M/2 - Ms/2$$

On comprendra que les « échantillons » $\tilde{l}_n$ sont en réalité des valeurs incomplètement décodées par synthèse et pondération en utilisant la fenêtre longue de synthèse. Il s'agit typiquement des valeurs $v_1$ de la figure 3a, multipliées par les coefficients h(M+n) de la fenêtre FLS, et dans lesquelles interviennent encore des échantillons de début de la trame $T_i$, tels que l'échantillon a.

On remarquera aussi que les échantillons b et les suivants sont, ici, déterminés en premier et s'écrivent dans la formule donnée ci-avant « $s_{M-1-n}$ », illustrant ainsi le renversement temporel que propose le traitement de décodage dans cette seconde forme de réalisation.

On remarque aussi que la pondération effectuée par la fenêtre longue de synthèse FLS est évitée car celle-ci se retrouve retirée du terme $w_{1,n}$ (du fait de la division par h(M+n)).

Par ailleurs, pour la reconstruction de la portion d'échantillons couverte à la fois par la fenêtre longue FL (front descendant) et la première fenêtre courte FC (front montant), correspondant à la région des échantillons e à f de la figure 3b, on applique plutôt la combinaison suivante de deux termes pondérés :

$$\hat{x}_n = w'_{1,n}\tilde{s}_m + w'_{2,n}\tilde{l}_n, \text{ avec } m = n - M/2 + Ms/2 \text{ et } M/2 - Ms/2 \le n < M/2 + Ms/2$$

Comme précédemment, les termes $\tilde{l}_n$ constituent les valeurs incomplètement reconstituées par synthèse et pondération par la fenêtre longue de synthèse FLS et les termes $\tilde{s}_n$ représentent les valeurs incomplètement reconstituées à partir du front montant de la première fenêtre de synthèse courte FCS.

Les fonctions de pondération $w_{1,n}$ et $w_{2,n}$ sont données ici par :

$$w'_{1,n} = \frac{h(n) - \dfrac{h_s(m)h_s(Ms-1-m)}{h(M-1-n)}}{h(M-1-n)h_s(M_s-1-m) + h(n)h_s(m)} \text{ et } w'_{2,n} = \frac{\dfrac{h_s(Ms-1-m)}{h(M-1-n)}}{h(M-1-n)h_s(M_s-1-m) + h(n)h_s(m)}$$

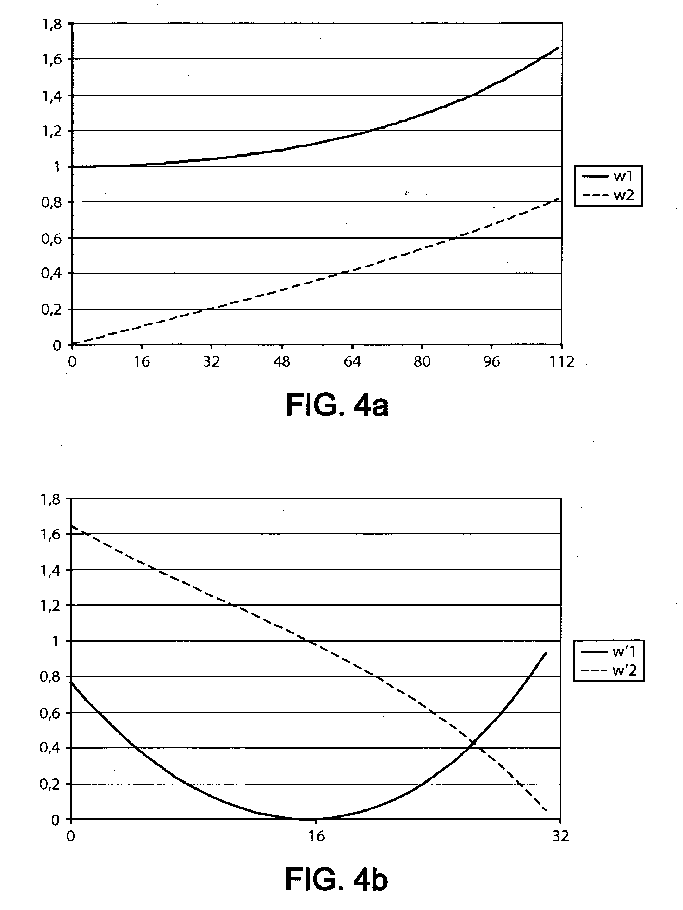

Toutes ces fonctions de pondération $w_{1,n}$, $w_{2,n}$, $w_{1,n}$ et $w_{2,n}$ sont constituées d'éléments figés qui ne dépendent que des fenêtres longues et courtes. Des exemples de variation de telles fonctions de pondération sont présentés sur les figures 4a et 4b. Dans une réalisation avantageuse, les valeurs prises par ces fonctions peuvent être calculées a priori (tabulées) et stockées définitivement en mémoire d'un décodeur au sens de l'invention.

Ainsi, en référence à la figure 5b, le traitement au décodage d'une trame $T'_i$ qui a été codée en passant directement d'une fenêtre d'analyse longue à une fenêtre d'analyse courte, peut comporter les étapes suivantes, dans un exemple de réalisation. Pour décoder la trame $T'_i$ (étape 60), on applique d'abord une fenêtre de synthèse courte (étape 61) pour décoder la valeur v2=b (étape 63) de fin de trame. On s'appuie ici sur une trame codée suivante $T'_{i+1}$ (étape 62) pour déterminer b. On applique ensuite une fenêtre de synthèse longue (étape 64) pour décoder les échantillons a de début de trame T'$_i$ (étape 65), en appliquant la compensation pour tout n compris entre 0 et M/2-Ms/2 à l'aide de la relation $\hat{x}_n = w_{1,n}\tilde{l}_n + w_{2,n}s_{M-1-n}$ (étape 67) et en utilisant les valeurs de pondération pré-calculées et tabulées $w_{1,n}$ et $w_{2,n}$ (étape 66).

Le décodage de la région « centrale » de la trame codée T'$_i$ (entre e et f), donc pour n compris entre M/2-Ms/2 et M/2+Ms/2, peut être mené en parallèle (signe « + » de la figure 5b) en utilisant à la fois les fenêtres de synthèse courte et longue (étape 68) et en appliquant en particulier la compensation (étape 69) à partir de la relation

$$\hat{x}_n = w'_{1,n}\tilde{s}_m + w'_{2,n}\tilde{l}_n ,$$ où $m = n - M / 2 + Ms / 2$ et avec les valeurs de pondération $w'_{1,n}$ et $w'_{2,n}$ pré-calculées et tabulées (étape 70). On déduit finalement de ce traitement (étape 71) les valeurs de tous les types d'échantillons a, b, e ou f de la trame initiale T$_i$.

Les première et seconde formes de réalisation décrites ci-avant, au décodage d'une trame T'$_i$ qui a été codée en passant directement d'une fenêtre d'analyse longue à une fenêtre d'analyse courte, garantissent une reconstruction parfaite et permettent alors, au codage, de passer effectivement d'une fenêtre longue à une fenêtre courte, directement.

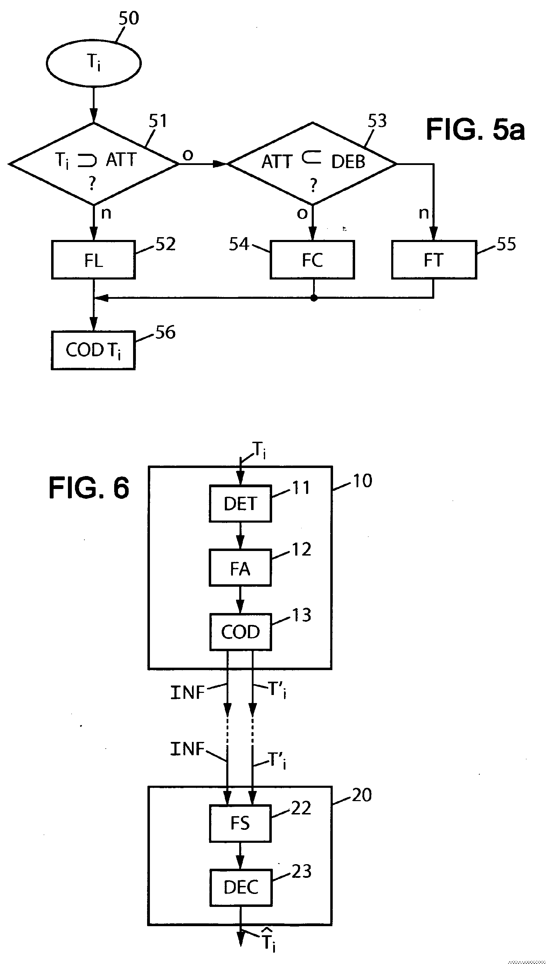

On décrit maintenant, en référence à la figure 5a, un exemple de réalisation dans lequel il est proposé de s'affranchir, au codage, de l'application d'une fenêtre de transition long-court, au moins dans certains cas.

Sur réception d'une trame T$_i$ (étape 50), on cherche dans le signal audionumérique présent directement dans cette trame T$_i$ la présence d'un phénomène non stationnaire, tel qu'une attaque ATT (test 51). Tant qu'aucun phénomène de ce type n'est détecté (flèche n en sortie du test 51), on continue l'application de fenêtres longues (étape 52) pour le codage de cette trame T$_i$ (étape 56). Sinon (flèche o en sortie du test 51), on cherche à déterminer si le phénomène ATT est au début (par exemple dans la première moitié) de la trame courante T$_i$ (test 53), auquel cas (flèche o en sortie du test 53) on applique directement une fenêtre courte (étape 54), et plus exactement une série de fenêtres courtes, pour le codage de la trame T$_i$ (étape 56). Cette réalisation permet alors d'éviter une fenêtre de transition et de ne pas attendre la trame suivante T$_{i+1}$ pour appliquer une fenêtre courte.

Ainsi, on comprendra que, contrairement à l'état de l'art, on peut détecter un événement particulier tel qu'un phénomène non stationnaire directement dans la trame en cours de codage T$_i$ et non pas dans une trame suivante T$_{i+1}$. Le retard du codage au sens de l'invention est alors réduit par rapport à celui de l'art antérieur. En effet, si le phénomène non stationnaire est détecté en début de trame courante, on applique directement une fenêtre courte, alors que dans l'art antérieur, il aurait fallu détecter le phénomène non stationnaire dans une trame suivante T$_{i+1}$ de manière à pouvoir appliquer une fenêtre de transition à la trame en cours de codage T$_i$.

En référence encore à la figure 5a, si le phénomène non stationnaire est détecté en fin (par exemple dans la seconde moitié) de la trame courante T$_i$ (flèche n en sortie du test 53), on peut avantageusement choisir d'appliquer une fenêtre de transition (étape 55) pour le codage de la trame en cours T$_i$ (étape 56), avant d'appliquer une succession de fenêtres courtes. Cette réalisation permet notamment de proposer un traitement équivalent à celui de l'état de l'art, tout en assurant un retard de codage réduit.

Ainsi, en termes plus génériques, on prévoit dans ce mode de réalisation au moins trois fenêtres de pondération :

- une fenêtre courte,
- une fenêtre longue, et
- une fenêtre de transition pour passer d'une utilisation de la fenêtre longue à une utilisation de la fenêtre courte,

et si un événement particulier tel qu'un phénomène non stationnaire est détecté en fin de trame courante (étape 53), on applique une fenêtre de transition (étape 55) pour coder (étape 56) la trame courante (T$_i$).

Dans une variante de ce mode de réalisation, il peut être prévu, pour un passage entre une utilisation de fenêtre longue à une utilisation de fenêtre courte :

- pour une trame courante T$_i$, d'utiliser une fenêtre longue FL,
- et pour une trame immédiatement consécutive T$_{i+1}$, d'utiliser directement une fenêtre courte FC, sans utiliser de fenêtre de transition, quand bien même l'événement particulier serait détecté en fin de trame courante.

Cette variante présente l'avantage suivant. Comme le codeur doit envoyer au décodeur une information de changement de type de fenêtre, cette information peut être codée sur un seul bit car il n'y a plus à informer le décodeur du choix entre une fenêtre courte et une fenêtre de transition.

On peut néanmoins conserver une fenêtre de transition pour passer d'une fenêtre courte à une fenêtre longue et, notamment pour assurer encore la transmission de l'information de changement de type de fenêtre sur un seul bit, suite à la réception d'une information de passage de la fenêtre longue à la fenêtre courte, le décodeur peut à cet effet :

- utiliser la fenêtre courte,

- puis, en l'absence de réception d'information de changement de type de fenêtre, utiliser une fenêtre de transition d'une fenêtre courte à une fenêtre longue,
- puis enfin, utiliser une fenêtre longue.

On a illustré sur la figure 6 la communication d'information du type de fenêtre utilisée au codage, d'un codeur 10 vers un décodeur 20. On rappelle que le codeur 10 comporte un module de détection 11 d'un événement particulier tel qu'une attaque forte dans le signal contenu dans une trame $T_i$ en cours de codage et qu'il déduit de cette détection le type de fenêtre à utiliser. A cet effet, un module 12 sélectionne le type de fenêtre à utiliser et transmet cette information au module 13 de codage qui délivre la trame $T'_i$ codée en utilisant la fenêtre d'analyse FA sélectionnée par le module 12. La trame codée $T'_i$ est transmise au décodeur 20, avec l'information INF sur le type de fenêtre utilisée au codage (généralement dans un même flux). Le décodeur 20 comporte un module 22 de sélection de fenêtre de synthèse FS selon l'information INF reçue du codeur 10 et le module 23 applique le décodage de la trame $T'_i$ pour délivrer une trame décodée $\hat{T}_i$.

La présente invention vise aussi un codeur tel que le codeur 10 de la figure 6 pour la mise en oeuvre du procédé au sens de l'invention et plus particulièrement pour la mise en oeuvre du traitement illustré sur la figure 5a, ou de sa variante décrite précédemment (transmission de l'information de changement de type de fenêtre sur un seul bit).

La présente invention vise aussi un programme informatique, destiné à être stocké en mémoire d'un tel codeur et comportant des instructions pour la mise en oeuvre d'un tel traitements, ou de sa variante, lorsqu'un tel programme est exécuté par un processeur du codeur. A ce titre, la figure 5a peut représenter l'organigramme d'un tel programme.

On rappelle que le codeur 10 utilise des fenêtres d'analyse FA et le décodeur 20 peut utiliser des fenêtres de synthèse FS, selon la seconde forme de réalisation précitée, ces fenêtres de synthèse étant homologues des fenêtres d'analyse FA, en procédant toutefois à la correction par compensation décrite précédemment (en utilisant les fonctions de pondération $w_{1,n}$, $w_{2,n}$, $w'_{1,n}$, et $w'_{2,n}$).

La présente invention vise aussi un autre programme informatique, destiné à être stocké en mémoire d'un décodeur par transformée tel que le décodeur 20 illustré sur la figure 6, et comportant des instructions pour la mise en oeuvre du décodage selon la première forme de réalisation, ou selon la seconde forme de réalisation décrite ci-avant en référence à la figure 5b, lorsqu'un tel programme est exécuté par un processeur de ce décodeur 20. A ce titre, la figure 5b peut représenter l'organigramme d'un tel programme.

La présente invention vise aussi le décodeur par transformée, lui-même, comportant alors une mémoire stockant les instructions d'un programme informatique pour le décodage.

En termes génériques, le procédé de décodage au sens de l'invention, par transformée, d'un signal représenté par une succession de trames qui ont été codées en utilisant au moins deux types de fenêtres de pondération, de longueurs respectives distinctes, se fait comme suit.

En cas de réception d'une information de passage d'une fenêtre longue à une fenêtre courte :

- on détermine des échantillons (de type b) à partir d'un décodage appliquant un type de fenêtre de synthèse courte FCS à une trame donnée $T'_{i+1}$ qui a été codée en utilisant une fenêtre d'analyse courte FC, et
- on obtient des échantillons complémentaires en :

  • décodant partiellement (application d'une transformée inverse $DCT^{-1}$) une trame $T'_i$ précédant la trame donnée et qui a été codée en utilisant un type de fenêtre d'analyse longue FL, et
  • en appliquant une combinaison de deux termes pondérés faisant intervenir des fonctions de pondération qui peuvent être tabulées et stockées en mémoire d'un décodeur.

Dans la seconde forme de réalisation ci-avant, il s'agit des fonctions notées $w_{1,n}$, $w_{2,n}$, $w'_{1,n}$, $w'_{2,n}$.

Toutefois, ce traitement générique au décodage s'applique dans les deux cas des première et seconde formes de réalisation.

Dans la seconde forme de réalisation :

- on détermine d'abord (étape 63 de la figure 5b) les échantillons (b) issus de la trame donnée ($T'_{i+1}$), et
- on en déduit (étapes 65-67) des échantillons (a) correspondant temporellement au début de la trame précédente ($T'_i$), ces échantillons étant issus d'un décodage appliquant une fenêtre de synthèse longue FLS et propre à la seconde forme de réalisation.

Dans ce cas, pour :

- une trame comportant M échantillons,
- une fenêtre longue comportant 2M échantillons,

- une fenêtre courte comportant 2Ms échantillons, Ms étant inférieur à M, les échantillons $\hat{x}_n$, pour n compris entre 0 et (M/2-Ms/2), n=0 correspondant au début d'une trame en cours de décodage, sont donnés par une combinaison de deux termes pondérés du type :

$$\hat{x}_n = w_{1,n}\tilde{l}_n + w_{2,n}s_{M-1-n} \text{ , où :}$$

où:
- $\tilde{l}_n$ sont des valeurs (v1) issues de la trame précédente $T'_i$,
- $s_{M-1-n}$ sont des échantillons (b) déjà décodés en utilisant des fenêtres de synthèse courtes appliquées à la trame donnée $T'_{i+1}$, et
- $w_{1,n}$ et $w_{2,n}$ sont des fonctions de pondération dont les valeurs prises en fonction de n peuvent être tabulées et stockées en mémoire du décodeur.

Sinon, pour n compris entre (M/2-Ms/2) et (M/2+Ms/2), les échantillons $\hat{x}_n$ sont donnés par une combinaison de deux termes pondérés du type : $\hat{x}_n = w'_{1,n}\tilde{s}_m + w'_{2,n}\tilde{l}_n$ , avec $m = n - M/2 + Ms/2$ , où :

- $\tilde{l}_n$ sont des valeurs v1 issues de la trame précédente $T'_i$,
- $\tilde{s}_m$ sont des valeurs v2 issues de la trame donnée $T'_{i+1}$, et
- $w'_{1,n}$ et $w'_{2,n}$ sont des fonctions de pondération dont les valeurs prises en fonction de n peuvent être aussi tabulées et stockées en mémoire du décodeur.

La présente invention permet donc d'offrir la transition entre fenêtres avec un retard réduit par rapport à l'art antérieur tout en conservant la propriété de reconstruction parfaite de la transformée. Ce procédé peut être appliqué avec tous types de fenêtres (fenêtres non symétriques et fenêtres d'analyse et synthèse différentes) et pour différentes transformées et bancs de filtres.

Les traitements de compensation présentés ci-dessus dans le cas d'une transition d'une fenêtre longue vers une fenêtre de taille plus courte s'étendent naturellement et de façon analogue au cas d'une transition d'une fenêtre courte vers une fenêtre de taille supérieure. Dans ce cas, l'absence de fenêtre de transition court-long peut être compensée au décodeur par une pondération analogue au cas présenté ci-dessus.

L'invention s'applique alors à tout codeur par transformée, notamment ceux prévus pour des applications conversationnelles interactives, comme dans la norme MPEG-4 « AAC - Low Delay », mais aussi à des transformées différentes des transformées MDCT, notamment les transformées précitées ELT (pour « *Extended Lapped Transform* ») et leurs extensions bi-orthogonales.

Toutefois, dans le cas d'une transformée de type ELT notamment, il a été observé que les termes de repliement temporel dus à la modulation (v1) peuvent se combiner avec des termes de repliement temporel provenant du passé. Ainsi, le traitement correctif présenté ci-avant tient compte d'un phénomène d'influence (ou « aliasing ») de futurs échantillons. En revanche, le développement présenté ci-après tient compte aussi des composantes passées afin de les annuler pour obtenir une reconstruction parfaite, tout au moins en l'absence de quantification. Il est donc proposé de définir ici une fonction de pondération supplémentaire qui, associée au signal passé synthétisé, permet de supprimer les termes de repliement temporel.

On prend ci-après, comme exemple de transformée ELT, celle décrite dans le document : "Modulated Filter Banks with Arbitrary System Delay: Efficient Implementations and the Time- Varying Case", Gerald D. T. Schuller, Tanja Karp, IEEE Transactions on Signal Processing, Vol. 48, No. 3 (Mars 2000).

L'exemple de réalisation ci-après propose, dans le cadre de la présente invention, un passage sans transition entre une fenêtre longue (par exemple de 2048 échantillons) et une fenêtre courte (par exemple de 128 échantillons).

* *Transformée avec fenêtre longue (K=4, M=512)*

Il s'agit d'une transformée à faible retard dont la fenêtre est de taille *K.M*=2048, et dont l'analyse s'écrit sous la forme :

$$X_{t,k} = -2 \cdot \sum_{n=-2M}^{2M-1} z_{t,n}^a \cos\left(\frac{\pi}{M}\left(n - \frac{M}{2} + \frac{1}{2}\right)\left(k + \frac{1}{2}\right)\right),$$

pour $0 \leq k \leq M\text{-}1$,

- M étant le nombre de composantes spectrales obtenues,

- $z_{t,n}^a = w_{LD}(2M - 1 - n) \cdot x_{n+tM}$, pour $-2M \leq n \leq 2M\text{-}1$, étant la notation du signal d'entrée fenêtré, et

- $w_{LD}(n) = w_L^s(n)$ étant la notation de la fenêtre de synthèse longue.

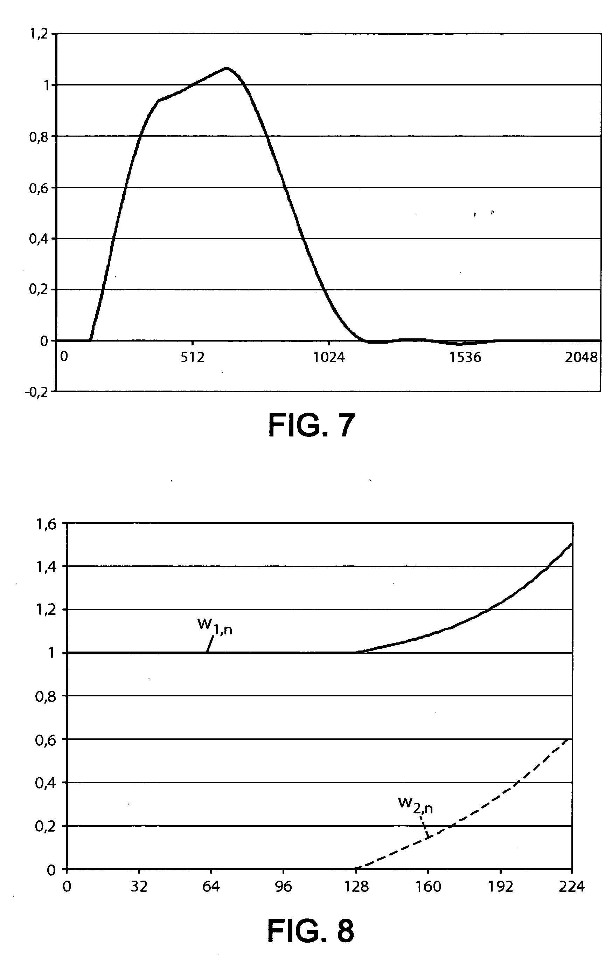

On a illustré sur la figure 7 cette fenêtre de synthèse longue pour le cas d'une transformée ELT à M=512 composantes et un coefficient de recouvrement K=4.

Le transformée inverse s'écrit:

$$x_{n+tM}^{inv} = -\frac{1}{M} \sum_{k=0}^{M-1} X_{t,k} \cos\left(\frac{\pi}{M}\left(n - \frac{M}{2} + \frac{1}{2}\right)\left(k + \frac{1}{2}\right)\right),$$

pour $0 \leq n \leq 4M\text{-}1$ et le signal reconstruit $X_{n+tM}$ est obtenu par addition recouvrement de quatre éléments ($K$=4):

$$x_{n+tM} = z_{t,n} + z_{t-1,n+M} + z_{t-2,n+2M} + z_{t-3,n+3M},$$

$$\text{et } z_{t,n} = w_{LD}(n).x_{n+tM}^{inv}$$

pour $0 \leq n \leq M\text{-}1$

On notera que la fenêtre de synthèse est définie comme suit : $w_L^s(n) = w_{LD}(n)$, pour $0 \leq n \leq 4M\text{-}1$, alors que la fenêtre d'analyse est définie à partir de la fenêtre de synthèse par inversion de l'ordre des échantillons, soit :

$$w_L^a(n) = w_{LD}(4M - 1 - n), \text{ pour } 0 \leq n \leq 4M\text{-}1.$$

*\* Transformée avec fenêtre courte (K=2, $M_s$=64)*

La transformée d'analyse s'écrit, dans le cas d'une fenêtre courte, sous la forme :

$$X_{t,k} = -2 \cdot \sum_{n=0}^{2M_s-1} z_{t,n}^a \cos\left(\frac{\pi}{M_s}\left(n - \frac{M_s}{2} + \frac{1}{2}\right)\left(k + \frac{1}{2}\right)\right),$$

pour $0 \leq k \leq M_s\text{-}1$
avec :

- $z_{t,n}^a = w_S(2M_s - 1 - n) \cdot x_{n+tM_s}$, pour $0 \leq n \leq 2M_s\text{-}1$, comme signal d'entrée fenêtre, et

- $w_S(n)$, comme fenêtre courte de synthèse.

La transformée inverse s'écrit :

$$x_{n+tM_s}^{inv} = -\frac{1}{M_S} \sum_{k=0}^{M_s-1} X_{t,k} \cos\left(\frac{\pi}{M_s}\left(n - \frac{M_s}{2} + \frac{1}{2}\right)\left(k + \frac{1}{2}\right)\right),$$

pour $0 \le n \le 2M_s$-1 et le signal reconstruit $x_{n+tM}$ est obtenu par addition recouvrement de deux éléments *(K_s = 2)* :

$$x_{n+tM_s} = z_{t,n} + z_{t-1,n+M_s}, \text{ pour } 0 \le n \le M_S - 1$$

$$\text{et } z_{t,n} = w_S(n).x_{n+tM_s}^{inv}$$

Dans cette notation, *t* est l'indice de la trame courte, et les fenêtres d'analyse et de synthèse sont identiques, car symétriques, avec :

$$w_a(n) = w_S(n) = \sin\left[\frac{\pi}{2M_s}(n + 0.5)\right], \quad 0 \le n < 2M_s$$

*\* Expressions des fonctions de pondération*

Dans ce mode de réalisation, pour :

- une trame comportant M échantillons,
- une fenêtre longue comportant 4M échantillons,
- une fenêtre courte comportant 2*Ms* échantillons, *Ms* étant inférieur à M,

pour n compris entre 0 et *M/2-Ms/2* (n=0 correspondant au début d'une trame en cours de décodage), les échantillons $\hat{x}_n$ sont donnés par une combinaison de quatre termes pondérés du type :

$$\hat{x}_n = w_{1,n}\tilde{l}_n + w_{2,n}s_{M-1-n} + w_{3,n}s_{n-2M} + w_{4,n}s_{-M-1-n},$$

avec $0 \le n \le M/2 - Ms/2$, où:
- $\hat{x}_n$ représente les échantillons décodés (correspondant aux échantillons initiaux $x_n$ si le codage/décodage est à reconstruction parfaite),
- la notation $\tilde{l}_n = z_{t,n+M} + z_{t-1,n+2M} + z_{t-2,n+3M}$ désigne ce qui correspondrait à des échantillons qui auraient été incomplètement décodés de la trame (T'$_i$) précédant la trame donnée (T'$_{i+1}$) (application d'une transformation inverse), en utilisant une fenêtre de synthèse longue avec addition aux éléments de mémoire précédents $z_{t-1,n+2M} + z_{t-2,n+3M}$, sans correction de la trame T'$_i$,
- $s_n$ représente les échantillons complètement décodés à l'aide de la succession de fenêtres courtes de synthèse FCS de la trame T'$_{i+1}$ (pour les échantillons d'indice *n* tel que $M/2+M_s/2 \le n \le M$) et les échantillons complètement décodés des trames précédentes (notés alors $s_{n-2M}$ pour $0 \le n \le M$, ce qui équivaut à {s$_{-2M}$,s$_{-2M+1}$, ..., s$_{-M-1}$}), et
- $w_{1,n}$, $w_{2,n}$, $w_{3,n}$ et $w_{4,n}$ sont des fonctions de pondération dont les valeurs prises en fonction de *n* peuvent être tabulées et stockées en mémoire du décodeur ou calculées en fonction des fenêtres d'analyse et de synthèse longues et courtes.

Avantageusement, il peut être choisi comme fonctions de pondération les expressions suivantes, notamment en vue d'assurer la reconstruction parfaite :
pour $0 \le n \le M/2 - Ms/2$

$$- \quad w_{1,n} = \frac{1}{h(M+n) \cdot h(M-1-n)}$$

$$- \quad w_{2,n} = \frac{h(n)}{h(M-n-1)}$$

$$- \quad w_{3,n} = -\frac{h(n)h(4M-1-n)}{h(M+n)\cdot h(M-1-n)}$$

$$- \quad w_{4,n} = -\frac{h(n)h(3M+n)}{h(M+n)\cdot h(M-1-n)}$$

On remarquera que les formes de $w_{1,n}$ et $w_{2,n}$ sont légèrement différentes de celles exposées précédemment dans le cas de la transformée MDCT. En effet, les filtres ne sont plus symétriques (de sorte que le terme $h^2$ disparaît) et les termes de modulation sont changés, ce qui explique le changement de signe.

Ensuite, toujours dans cet exemple de réalisation, pour n compris entre $M/2-Ms/2$ et $M/2+Ms/2,$ les échantillons $\hat{x}_n$ sont donnés par une combinaison de quatre termes pondérés du type :

$$\hat{x}_n = w'_{1,n}\tilde{l}_n + w'_{2,n}\tilde{s}_m + w'_{3,n}s_{n-2M} + w'_{4,n}s_{-M-1-n} \,,$$

avec $m = n - M/2 + Ms/2$ et $M/2 - Ms/2 \le n < M/2 + Ms/2$.

Selon les mêmes notations :

- $\tilde{l}_n$ sont des échantillons incomplètement décodés de la trame T'$_i$ précédant la trame donnée T'$_{i+1}$,
- $\tilde{s}_m$ sont des échantillons incomplètement décodés de la première fenêtre courte de la trame donnée T'$_{i+1}$, et
- $s_n$ représente les échantillons complètement décodés aux trames précédentes (T'$_{i-1}$, T'$_{i-2}$,...), et
- $w'_{1,n}$, $w'_{2,n}$, $w'_{3,n}$ et $w'_{4,n}$ sont des fonctions de pondération dont les valeurs prises en fonction de n peuvent aussi être tabulées et stockées en mémoire du décodeur ou calculées en fonction des fenêtres d'analyse et de synthèse longues et courtes.

Avantageusement, il peut être choisi des fonctions de pondération selon les formes suivantes afin d'assurer la reconstruction parfaite :

pour $M/2 - Ms/2 \le n < M/2 + Ms/2$, $m = n - M/2 + Ms/2$,

$$- \quad w'_{1,n} = \frac{\dfrac{h_s(Ms-1-m)}{h(M+n)}}{h(M-1-n)h_s(M_s-1-m)+h(n)h_s(m)}$$

$$- \quad w'_{2,n} = \frac{h(n)-\dfrac{h_s(m)h_s(Ms-1-m)}{h(M+n)}}{h(M-1-n)h_s(M_s-1-m)+h(n)h_s(m)}$$

$$- \quad w'_{3,n} = -h(n)h(4M-1-n)\frac{\dfrac{h_s(Ms-1-m)}{h(M+n)}}{h(M-1-n)h_s(M_s-1-m)+h(n)h_s(m)}$$

$$- \quad w'_{4,n} = -h(n)h(3M+n)\dfrac{\dfrac{h_s(Ms-1-m)}{h(M+n)}}{h(M-1-n)h_s(M_s-1-m)+h(n)h_s(m)}$$

Ainsi, dans ce mode de réalisation, lors d'une transition entre fenêtre longue et fenêtre courte, le signal est reconstruit à partir de la combinaison :

- d'une version pondérée des échantillons reconstruits à partir des fenêtres courtes,
- d'une version pondérée des échantillons partiellement reconstruits à partir de la fenêtre longue (intégrant les termes de mémoire $z_{t-1,n+2M} + z_{t-2,n+3M}$)
- et d'une version pondérée d'une combinaison des échantillons du signal synthétisé passé.

Dans une variante de ce mode de réalisation, on remarquera que les fonctions $w'_{3,n}$ et $w'_{4,n}$ diffèrent peu l'une de l'autre. Seuls les termes $h(4M-1-n)$ et $h(3M+n)$ diffèrent dans leur expression. Un mode de réalisation peut par exemple consister à préparer les termes $h(4M-1-n)s_{n-2M} + h(3M+n)s_{-M-1-n}$, puis pondérer le résultat par une fonction qui s'exprime par :

$$w''_{3-4,n} = -h(n)\dfrac{\dfrac{h_s(Ms-1-m)}{h(M+n)}}{h(M-1-n)h_s(M_s-1-m)+h(n)h_s(m)}$$

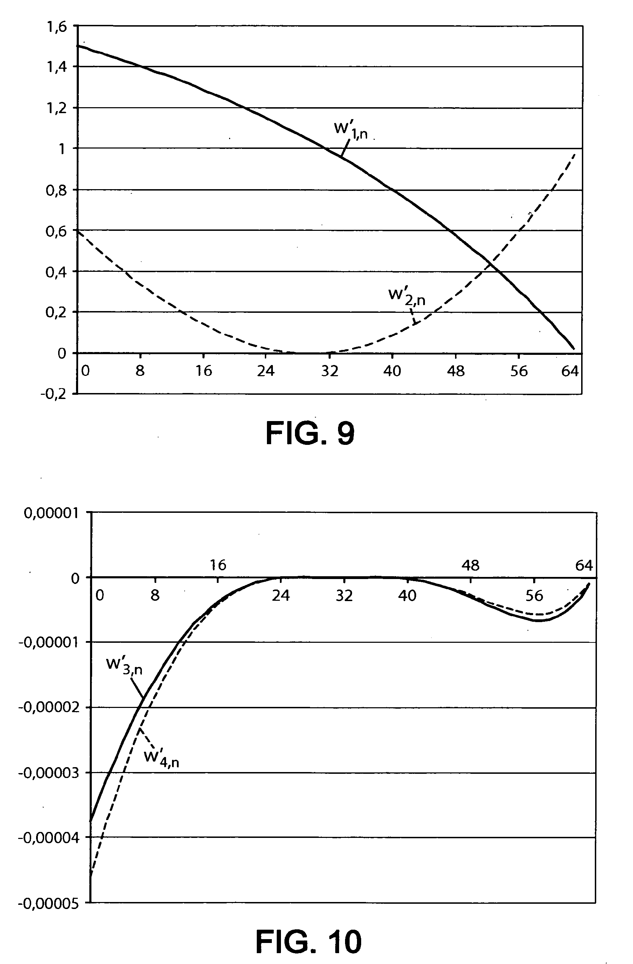

et qui correspond donc aux fonctions $w'_{3,n}$ et $w'_{4,n}$ dont on a retiré les contributions des termes $h(4M-1-n)$ et $h(3M+n)$.
Ce même principe s'applique de façon analogue à $w_{3,n}$ et $w_{4,n}$.
Dans une autre variante, la mémoire de synthèse est pondérée. Avantageusement, cette pondération peut être une mise à zéro des mémoires de synthèse de sorte que les échantillons incomplètement reconstruits à partir de la fenêtre longue sont additionnés à une mémoire $z_{t-1,n+2M} + z_{t-2,+3M}$ pondérée. Dans ce cas, la pondération appliquée au signal synthétisé passé peut être différente.
On a représenté sur les figures 9 et 10 les formes caractéristiques des fonctions de pondération w et w' obtenues dans le mode de réalisation exposé précédemment. En particulier, en se référant aux valeurs en ordonnées de ces graphes, il apparaît que les fonctions $w'_{3,n}$ et $w'_{4,n}$ représentées sur la figure 10 peuvent être négligées (compte tenu de leurs valeurs prises) par rapport aux fonctions $w'_{1,n}$ et $w'_{2,n}$ représentées sur la figure 9. Les termes dans lesquels interviennent les fonctions $w'_{3,n}$ et $w'_{4,n}$ pourraient donc être omis dans la somme $\hat{x}_n$ qui était donnée ci-avant en vue de la reconstruction du signal $\hat{x}_n$. Cette omission entrainerait une faible erreur de reconstruction.
Dans une variante visant encore à gagner en simplicité de traitement, il apparaît aussi que $w'_{3,n}$ et $w'_{4,n}$ sont très similaires. Il pourrait donc être prévu de n'utiliser qu'une combinaison de ces deux pondérations, par exemple une moyenne des deux fonctions, afin de gagner en temps de calcul.
La comparaison des figures 8 (représentant l'allure des fonctions de pondération $w_{1,n}$ et $w_{2,n}$) et 12 (représentant l'allure des fonctions de pondération $w_{3,n}$ et $w_{4,n}$) appelle les mêmes remarques pour les fonctions $w_{3,n}$ et $w_{4,n}$ par rapport aux fonctions $w_{1,n}$ et $w_{2,n}$.
On pourra donc simplifier les expressions précédentes de $\hat{x}_n$ :

- en $\hat{x}_n = w_{1,n}\tilde{l}_n + w_{2,n}s_{M-1-n}$ [1], si les pondérations par les fonctions $w_{3,n}$ et $w_{4,n}$ sont omises,
- ou en $\hat{x}_n = w_{1,n}\tilde{l}_n + w_{2,n}s_{M-1-n} + w_{3-4,n}(s_{n-2M} + s_{-M-1-n})$ [2],

avec, par exemple, $w_{3-4,n} = \dfrac{1}{2}\left(w_{3,n} + w_{4,n}\right)$ ou toute autre combinaison linéaire de ces deux fonctions qui entrainerait une erreur de reconstruction modérée.
Il convient de noter que l'omission des pondérations par les fonctions $w_{3,n}$ et $w_{4,n}$ entraîne une erreur de reconstruction d'une puissance de 84 dB sous le signal et que l'utilisation d'une simple combinaison linéaire (moyenne de ces fonctions par exemple) entraîne quant à elle une erreur de 96 dB sous le signal, ce qui, dans un cas comme dans l'autre, est déjà très satisfaisant pour des applications audio. On indique qu'une reconstruction parfaite permet couramment de mesurer en pratique une puissance d'erreur de 120 à 130 dB sous le signal.

De plus, ne pas utiliser les termes de mémoire $s_{n-2M}$ et $s_{-M-1-n}$ dans la pondération [1] permet d'éviter l'étalement de bruit de quantification venant du passé. On échange donc une reconstruction imparfaite en absence de quantification contre une limitation du bruit de quantification lorsque le signal est codé *in fine.*

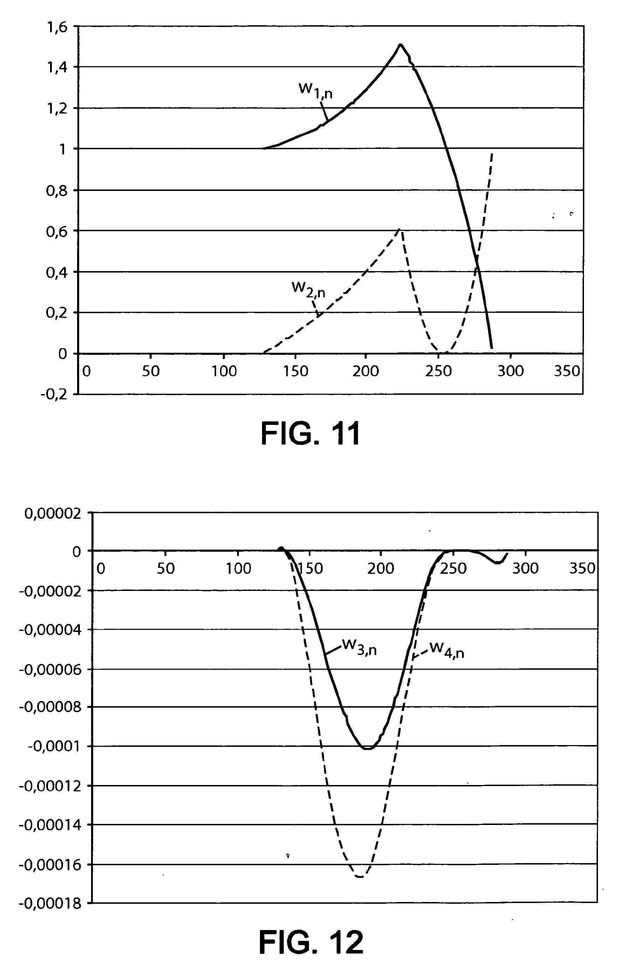

On remarque aussi que, sur le support temporel 0-128 (figures 8 et 12), les fonctions de pondération ont les formes particulières :

$$\begin{cases} w_{1,n} = 1 \\ w_{2,n} = 0 \\ w_{3,n} = 0 \\ w_{4,n} = 0 \end{cases}$$

Cette observation s'explique par la forme de la fenêtre $h(n)$ (figure 7) qui comporte dans l'exemple décrit une première partie d'amplitude nulle entre 0 et 128. En conséquence, dans cet exemple, il est préférable, en termes de complexité, de décomposer la première reconstruction en deux phases :

- $\hat{x}_n = \tilde{l}_n$, pour $0 \le n < 128$

- et $\hat{x}_n = w_{1,n}l_n + w_{2,n}s_{M-1-n} + w_{3,n}s_{n-2M} + w_{4,n}s_{-M-1-n}$, pour $128 \le n < M/2 - Ms/2 = 224$.

Dans une réalisation à structure algorithmique avantageuse, les fonctions de pondération $w_{1,n}$ et $w_{2,n}$ (figure 11), d'une part, et $w_{3,n}$ et $w_{4,n}$ (figure 12), d'autre part, peuvent être définies sur tout l'intervalle allant de 0 à $(M+Ms)/2$, comme exposé ci-après.

Dans une première étape, on calcule de 0 à $(M+Ms)/2,$ une expression primaire (notée $\tilde{x}_n$) du signal $\hat{x}_n$ à reconstruire, comme suit :
*$\hat{x}_n = w_{1,n}l_n + w_{3,n}s_{n-2M} + w_{4,n}s_{-M-1-n}$ (d'où le calcul de la fonction $w_{1,n}$ illustrée sur toute la plage de n comprise entre 0 et M/2+Ms/2 sur la figure 11, ainsi que des fonctions $w_{3,n}$ et $w_{4,n}$ calculées sur cette même plage et illustrées sur la figure 12).

Ensuite, pour n compris entre 0 et $M/2-Ms/2$ (n=0 correspondant au début d'une trame en cours de décodage), on pose :
* $\tilde{x}_n = \tilde{x}_n + w_{2,n}s_{M-1-n}$ où $w_{2,n}$ correspondant au début de la courbe référencée $w_{2,n}$ sur la figure 11 (avant l'abscisse 224).
et pour n compris entre $M/2-Ms/2$ et $M/2+Ms/2,$ on pose :

$$\hat{x}_n = \tilde{x}_n + w'_{2,n}\tilde{s}_m ,$$ avec $m = n - M/2 + Ms/2$ et $M/2 - Ms/2 \le n < M/2 + Ms/2,$ et où $w'_{2,n}$ correspondant à la fin de la courbe référencée $w_{2,n}$ sur la figure 11 (après l'abscisse 224).

Cette distinction de traitement particulière pour la pondération par les fonctions $w_{2,n}$ et $w'_{2,n}$ s'explique comme suit.

Pour chaque fonction $w_{1,n}$, $w_{3,n}$ et $w_{4,n}$ il est possible de n'utiliser qu'une seule variation entre 0 et M/2+Ms/2. En revanche, pour les fonctions $w_{2,n}$ et $w'_{2,n}$ :

- la fonction $w_{2,n}$ pondère les échantillons complètement décodés,
- tandis que la fonction $w'_{2,n}$ pondère des échantillons incomplètement décodés.

Par ailleurs, on notera un « renversement temporel » du traitement pour la pondération $w_{2,n}$ seulement (indice de s en -n) et pas pour la pondération $w'_{2,n}$.

Ainsi, pour résumer par des termes génériques ce développement permettant de réduire l'influence des échantillons passés, pour le décodage complet des échantillons, lors d'une transition d'une fenêtre longue (avec un recouvrement K>2) vers une fenêtre courte (avec un recouvrement K'<K), les échantillons décodés sont obtenus par combinaison d'au moins deux termes pondérés faisant intervenir le signal de synthèse passé.

**Revendications**

1. Procédé de décodage, par transformée, d'un signal représenté par une succession de trames qui ont été codées en utilisant au moins deux types de fenêtres de pondération, de longueurs respectives distinctes, dans lequel, en cas de réception d'une information de passage d'une fenêtre longue à une fenêtre courte et pour compenser une transition directe de la fenêtre longue à la fenêtre courte:

- on détermine (63) des échantillons (**b**) à partir d'un décodage appliquant un type de fenêtre de synthèse courte (61) à une trame donnée ($T'_{i+1}$) qui a été codée en utilisant une fenêtre d'analyse courte, et
- on obtient des échantillons complémentaires (67,69) en :

• décodant partiellement ($DCT^{-1}$) une trame ($T'_i$) précédant la trame donnée et qui a été codée en utilisant un type de fenêtre d'analyse longue, et
• en appliquant une combinaison d'au moins deux valeurs :

- issues d'échantillons respectivement de la trame donnée ($T'_{i+1}$) et d'au moins une trame ($T'_i$) précédant la trame donnée ($T'_{i+1}$),
- et pondérées par des fonctions de pondération respectives ($w_{1,n}$, $w_{2,n}$; $w'_{1,n}$, $w'_{2,n}$) tabulées et stockées en mémoire d'un décodeur.

**2.** Procédé selon la revendication 1, **caractérisé en ce que** :

- on détermine d'abord (63) les échantillons (**b**) issus de la trame donnée ($T'_{i+1}$), et
- on en déduit (65-67) des échantillons (**a**) correspondant temporellement au début de la trame précédente ($T'_i$), ces échantillons étant issus d'un décodage appliquant une fenêtre de synthèse longue.

**3.** Procédé selon la revendication 2, dans lequel :

- une trame comporte M échantillons,
- une fenêtre longue comporte 2M échantillons,
- une fenêtre courte comporte 2Ms échantillons, Ms étant inférieur à M,

**caractérisé en ce que** les échantillons $\hat{x}_n$, pour n compris entre 0 et (M/2-Ms/2), n=0 correspondant au début d'une trame en cours de décodage, sont donnés par une combinaison de deux termes pondérés du type :
$\hat{x}_n = w_{1,n}l_n + w_{2,n}s_{M-1-n}$, où:

- $\tilde{l}_n$ sont des valeurs (vl) issues de la trame précédente ($T'_i$),
- $s_{M-1-n}$ sont des échantillons (**b**) déjà décodés en utilisant des fenêtres de synthèse courtes appliquées à la trame donnée ($T'_{i+1}$), et
- $w_{1,n}$ et $w_{2,n}$ sont des fonctions de pondération dont les valeurs prises en fonction de n sont tabulées et stockées en mémoire du décodeur.

**4.** Procédé selon l'une des revendications 1 à 3, dans lequel :

- une trame comporte M échantillons,
- une fenêtre longue comporte 2M échantillons,
- une fenêtre courte comporte 2Ms échantillons, Ms étant inférieur à M,
**caractérisé en ce que** les échantillons $\hat{x}_n$, pour n compris entre (M/2-Ms/2) et (M/2+Ms/2), n=0 correspondant au début d'une trame en cours de décodage, sont donnés par une combinaison de deux termes pondérés du type :

$$\hat{x}_n = w'_{1,n}\tilde{s}_m + w'_{2,n}\bar{l}_n \,, \text{ avec } m = n\text{-}M/2\text{+}Ms/2, \text{ où:}$$
- $\bar{l}_n$ sont des valeurs (v1) issues de la trame précédente ($T'_i$),
- $\tilde{s}_m$ sont des valeurs (v2) issues de la trame donnée ($T'_{i+1}$), et
- $w'_{1,n}$ et $w'_{2,n}$ sont des fonctions de pondération dont les valeurs prises en fonction de n sont tabulées et stockées en mémoire du décodeur.

**5.** Procédé selon l'une des revendications 1 à 4, **caractérisé en ce que**, pour un décodage de trames codées par un codage par transformée avec recouvrement, en vue de réduire une influence d'échantillons passés, le signal à décoder est reconstruit à partir d'une combinaison entre :

- une pondération d'échantillons reconstruits à partir de fenêtres courtes,

- une pondération d'échantillons partiellement reconstruits à partir d'une fenêtre longue, et
- une pondération d'échantillons du signal décodé passé.

**6.** Procédé selon la revendication 5, **caractérisé en ce que**, avec :

- une trame comportant $M$ échantillons,
- une fenêtre longue comportant $4M$ échantillons,
- une fenêtre courte comportant $2Ms$ échantillons, $Ms$ étant inférieur à $M$,

pour un indice d'échantillon n compris entre 0 et $M/2-Ms/2$, n=0 correspondant au début d'une trame en cours de décodage, les échantillons $\hat{x}_n$ à décoder sont donnés par une combinaison de quatre termes pondérés du type :

$\hat{x}_n = w_{1,n}\tilde{l}_n + w_{2,n}s_{M-1-n} + w_{3,n}s_{n-2M} + w_{4,n}s_{-M-1-n}$, avec $0 \leq n < M/2-Ms/2$, où:

- la *notation* $l_n = z_{1,n+M} + z_{t-1,n+2M} + z_{t-2,n+3M}$ désigne des échantillons incomplètement décodés de la trame (T'$_i$) précédant la trame donnée (T'$_{i+1}$), en utilisant une fenêtre de synthèse longue avec addition sans correction à des éléments de mémoire précédents notés $z_{t-1,n+2M} + z_{t-2,n+3M}$, l'indice $t$ étant un indice de trame,

- $s_n$ représente des échantillons complètement décodés à l'aide d'une succession de fenêtres courtes de synthèse (FCS) de la trame donnée (T'$_{i+1}$), pour $M/2+M_s/2 \leq n < M$, et des échantillons complètement décodés de trames précédentes (T'$_i$, T'$_{i-1}$, T'$_{i-2}$,...), pour $-2M \leq n < M$, et

- $w_{1,n}$, $w_{2,n}$, $w_{3,n}$ et $w_{4,n}$ sont respectivement des première, deuxième, troisième et quatrième fonctions de pondération dépendantes de l'indice d'échantillon n et les valeurs prises au moins par les première et deuxième fonctions de pondération $w_{1,n}$ et $w_{2,n}$, en fonction de n, sont tabulées et stockées en mémoire du décodeur.

**7.** Procédé selon l'une des revendications 5 et 6, **caractérisé en ce que**, avec :

- une trame comportant $M$ échantillons,
- une fenêtre longue comportant $4M$ échantillons,
- une fenêtre courte comportant $2Ms$ échantillons, $Ms$ étant inférieur à $M$,

pour n compris entre $M/2-Ms/2$ et $M/2+Ms/2$, les échantillons $\hat{x}_n$ à décoder sont donnés par une combinaison de quatre termes pondérés du type :

$$\hat{x}_n = w'_{1,n}\tilde{l}_n + w'_{2,n}\tilde{s}_m + w'_{3,n}s_{n-2M} + w'_{4,n}s_{-M-1-n}, \text{ où :}$$

- $l_n$ sont des échantillons incomplètement décodés de la trame (T'$_i$) précédant la trame donnée (T'$_{i+1}$),
- $\tilde{s}_m$ sont des échantillons incomplètement décodés de la première fenêtre courte de la trame donnée (T'$_{i+1}$), avec $m = n-M/2+Ms/2$,
- $s_n$ représente les échantillons complètement décodés de trames précédentes (T'$_i$, T'$_{i-1}$, T'$_{i-2}$,...),
- $w'_{1,n}$, $w'_{2,n}$, $w'_{3,n}$ et $w'_{4,n}$ sont respectivement des première, deuxième, troisième et quatrième fonctions de pondération dépendantes de n et les valeurs prises au moins par les première et deuxième fonctions de pondération $w'_{1,n}$ et $w'_{2,n}$, en fonction de n, sont tabulées et stockées en mémoire du décodeur.

**8.** Procédé selon l'une des revendications 6 et 7, **caractérisé en ce que** les contributions des troisième et quatrième fonctions de pondération ($w_{3,n}$, $w_{4,n}$ ; $w'_{3,n}$, $w'_{4,n}$) sont négligées dans le calcul des échantillons $\hat{x}_n$ de sorte que seules les valeurs prises par les première et deuxième fonctions de pondération ($w_{1,n}$, $w_{2,n}$ ; $w'_{1,n}$, $w'_{2,n}$), en fonction de n, sont tabulées et stockées en mémoire du décodeur.

**9.** Procédé selon l'une des revendications 6 et 7, **caractérisé en ce que** les troisième et quatrième fonctions de pondération ($w_{3,n}$, $w_{4,n}$ ; $w'_{3,n}$, $w'_{4,n}$) sont données par une unique fonction de pondération ($w_{3-4,n}$ ; $w'_{3-4,n}$) découlant d'une combinaison linéaire desdites troisième et quatrième fonctions de pondération ($w_{3,n}$, $w_{4,n}$ ; $w'_{3,n}$, $w'_{4,n}$), de sorte que seules les valeurs prises par les première et seconde fonctions de pondération ($w_{1,n}$, $w_{2,n}$ ; $w'_{1,n}$, $w'_{2,n}$), ainsi que les valeurs prises par ladite unique fonction de pondération ($w_{3-4,n}$ ; $w'_{3-n}$), en fonction de n, sont tabulées et stockées en mémoire du décodeur.

**10.** Procédé selon les revendications 6 et 7, **caractérisé en ce que** :

- on calcule pour n allant de 0 à $(M+Ms)/2$, une expression primaire $\hat{x}_n$ du signal $\hat{x}_n$ à décoder, selon une combinaison pondérée du type :

$$\tilde{x}_n = w_{1,n}\tilde{l}_n + w_{3,n}s_{n-2M} + w_{4,n}s_{-M-1-n} \ ,$$

- pour n compris entre 0 et $M/2$-$Ms/2$, n=0 correspondant au début d'une trame en cours de décodage, on pose :

$$* \ \hat{x}_n = \tilde{x}_n + w_{2,n}s_{M-1-n} \ , \text{ et}$$

- pour n compris entre $M/2$-$Ms/2$ et $M/2$+$Ms/2$, on pose : $* \ \hat{x}_n = \tilde{x}_n + w'_{2,n}\tilde{s}_m$ , avec $m = n - M/2 + Ms/2$.

**11.** Décodeur par transformée, d'un signal représenté par une succession de trames issues d'un codeur utilisant au moins deux types de fenêtres de pondération, de longueurs respectives distinctes, **caractérisé en ce qu'**il comporte au moins:

- des moyens de réception d'une information de passage d'une fenêtre longue à une fenêtre courte; et, pour compenser une transition directe de la fenêtre longue à la fenêtre courte:
- des moyens de détermination d'échantillons (**b**) à partir d'un décodage appliquant un type de fenêtre de synthèse courte (61) à une trame donnée ($T'_{i+1}$) qui a été codée en utilisant une fenêtre d'analyse courte, ainsi que
- des moyens d'obtention d'échantillons complémentaires (67,69) apte à :

• décoder partiellement (DCT$^{-1}$) une trame ($T'_i$) précédant la trame donnée et qui a été codée en utilisant un type de fenêtre d'analyse longue, et
• à appliquer une combinaison d'au moins deux valeurs :

- issues d'échantillons respectivement de la trame donnée ($T'_{i+1}$) et d'au moins une trame ($T'_i$) précédant la trame donnée ($T'_{i+1}$),
- et pondérées par des fonctions de pondération respectives ($w_{1,n}$, $w_{2,n}$ ; $w'_{1,n}$, $w'_{2,n}$) tabulées et stockées en mémoire d'un décodeur.

**12.** Programme informatique, destiné à être stocké en mémoire d'un décodeur par transformée, **caractérisé en ce qu'**il comporte des instructions pour la mise en oeuvre du procédé de décodage selon l'une des revendications 1 à 10, lorsqu'il est exécuté par un processeur d'un tel décodeur.

**13.** Décodeur par transformée selon la revendication 11, **caractérisé en ce qu'**il comporte une mémoire stockant les instructions d'un programme informatique selon la revendication 12.

**Claims**

**1.** Transform decoding method, for a signal represented by a succession of frames which have been coded using at least two types of weighting windows, of different respective lengths, in which, in the event of receipt of an indication of transition from a long window to a short window and to compensate for a direct transition from the long window to the short window:

- samples (**b**) are determined (63) from a decoding applying a short synthesis type of window (61) to a given frame ($T'_{i+1}$) which has been coded by using a short analysis window, and
- complementary samples (67, 69) are obtained by:

• partially decoding (DCT$^{-1}$) a frame ($T'_i$) preceding the given frame and which has been coded by using a long analysis type of window, and
• applying a combination of at least two values:

- derived from samples respectively of the given frame ($T'_{i+1}$) and of at least one frame ($T'_i$) preceding the given frame ($T'_{i+1}$) ,
- and weighted by respective weighting functions ($w_{1,n}$, $w_{2,n}$; $w'_{1,n}$, $w'_{2,n}$) tabulated and stored in the memory of a decoder.

**2.** Method according to Claim 1, **characterized in that**:

- samples (**b**) derived from the given frame ($T'_{i+1}$) are first determined (63), and
- samples (**a**) corresponding time-wise to the start of the preceding frame ($T'_i$) are deduced (65-67) therefrom, these samples being derived from a decoding applying a long synthesis window.

**3.** Method according to Claim 2, in which:

- a frame comprises M samples,
- a long window comprises 2M samples,
- a short window comprises 2Ms samples, Ms being less than M,

**characterized in that** the samples $\hat{x}_n$, for n between 0 and (M/2-Ms/2), n = 0 corresponding to the start of a frame being decoded, are given by a combination of two weighted terms of the type:
$\hat{x}_n = w_{1,n}\tilde{l}_n + w_{2,n}\tilde{s}_{M-1-n}$, in which:

- $\tilde{l}_n$ are values (v1) derived from the preceding frame ($T'_i$),
- $\tilde{s}_{M-1-n}$ are samples (**b**) already decoded by using short synthesis windows applied to the given frame ($T'_{i+1}$), and
- $w_{1,n}$ and $w_{2,n}$ are weighting functions whose values, taken as a function of n, are tabulated and stored in the memory of the decoder.

**4.** Method according to one of Claims 1 to 3, in which:

- a frame comprises M samples,
- a long window comprises 2M samples,
- a short window comprises 2Ms samples, Ms being less than M,
**characterized in that** the samples $\hat{x}_n$, for n between (M/2-Ms/2) and (M/2+Ms/2), n = 0 corresponding to the start of a frame being decoded, are given by a combination of two weighted terms of the type:
$\hat{x}_n = w'_{1,n} \tilde{s}_m + w'_{2,n} \tilde{l}_n$, with m = n - M/2 + Ms/2,
in which:
- $\tilde{l}_n$, are values (v1) derived from the preceding frame ($T'_i$),
- $\tilde{s}_m$ are values (v2) derived from the given frame ($T'_{i+1}$), and
- $w'_{1,n}$ and $w'_{2,n}$ are weighting functions whose values, taken as a function of n, are tabulated and stored in the memory of the decoder.

**5.** Method according to one of Claims 1 to 4, **characterized in that**, for a decoding of frames coded by an overlap transform coding, in order to reduce influence from past samples, the signal to be decoded is reconstructed based on a combination of:

- a weighting of samples reconstructed from short windows,
- a weighting of samples partially reconstructed from a long window, and
- a weighting of samples from the past decoded signal.

**6.** Method according to Claim 5, **characterized in that**, with:

- a frame comprising *M* samples,
- a long window comprising *4M* samples,
- a short window comprising *2Ms* samples, *Ms* being less than *M*,
for a sample index n of between 0 and *M/2-Ms/2*, n = 0 corresponding to the start of a frame being decoded, the samples $\hat{x}_n$ to be decoded are given by a combination of four weighted terms of the type:
$\hat{x}_n = w_{1,n}\tilde{l}_n + w_{2,n}\tilde{s}_{M-1-n} + w_{3,n}\tilde{s}_{n-2M} + w_{4,n}\tilde{s}_{-M-1-n}$,
with $0 \leq n < M/2-Ms/2$, in which:
- the notation $\tilde{l}_n = z_{t,n+M} + z_{t-1,n+aM} + z_{t-2,n+3M}$ designates the incompletely decoded samples of the frame ($T'_i$) preceding the given frame ($T'_{i+1}$), by using a long synthesis window with uncorrected addition to preceding memory elements denoted $z_{t-1,n+aM} + z_{t-2,n+3M}$, the index t being a frame index,
- $\tilde{s}_n$ represents samples completely decoded using a succession of short synthesis windows (FCS) of the given frame ($T'_{i+1}$) , for $M/2 + M_s/2 \leq n < M$, and completely decoded samples from preceding frames ($T'_i$, $T'_{i-1}$, $T'_{i-2}$,...), for $-2M \leq n < M$, and
- $w_{1,n}$, $w_{2,n}$, $w_{3,n}$ and $w_{4,n}$ are respectively first, second, third and fourth weighting functions dependent on the sample index n and the values taken at least by the first and second weighting functions $w_{1,n}$ and $w_{2,n}$, as a function of n, are tabulated and stored in the memory of the decoder.

7. Method according to one of Claims 5 and 6, **characterized in that**, with:

- a frame comprising $M$ samples,
- a long window comprising 4M samples,
- a short window comprising $2Ms$ samples, $Ms$ being less than $M$,

for n between $M/2-Ms/2$ and $M/2+Ms/2$, the samples $\hat{x}_n$ to be decoded are given by a combination of four weighted terms of the type:

$x_n = w'_{1,n} \tilde{l}_n, + w'_{2,n}\tilde{s}_m + w'_{3,n}s_{n-2M} + w'_{4,n}s_{-M-1-n}$,

in which:

- $\tilde{l}_n$ are samples incompletely decoded from the frame ($T'_i$) preceding the given frame ($T'_{i+1}$),
- $\tilde{s}_m$ are samples incompletely decoded from the first short window of the given frame ($T'_{i+1}$), with $m = n-M/2 + Ms/2$,
- $S_n$ represents the completely decoded samples from preceding frames ($T'_i$, $T'_{i-1}$, $T'_{i-2}$,...),
- $w'_{1,n}$, $w'_{2,n}$, $w'_{3,n}$ and $w'_{4,n}$ are respectively first, second, third and fourth weighting functions dependent on n and the values taken at least by the first and second weighting functions $w'_{1,n}$ and $w'_{2,n}$, as a function of n, are tabulated and stored in the memory of the decoder.

8. Method according to one of Claims 6 and 7, **characterized in that** the contributions of the third and fourth weighting functions ($w_{3,n}$, $w_{4,n}$; $w'_{3,n}$, $w'_{4,n}$) are disregarded in the calculation of the samples $\hat{x}_n$ such that only the values taken by the first and second weighting functions ($w_{1,n}$, $w_{2,n}$; $w'_{1,n}$, $w'_{2,n}$), as a function of n, are tabulated and stored in the memory of the decoder.

9. Method according to one of Claims 6 and 7, **characterized in that** the third and fourth weighting functions ($w_{3,n}$, $w_{4,n}$; $w'_{3,n}$, $w'_{4,n}$) are given by a single weighting function ($w_{3-4,n}$; $w'_{3-4,n}$) devolving from a linear combination of said third and fourth weighting functions ($w_{3,n}$, $w_{4,n}$; $w'_{3,n}$, $w'_{4,n}$), such that only the values taken by the first and second weighting functions ($w_{1,n}$, $w_{2,n}$; $w'_{1,n}$, $w'_{2,n}$), and the values taken by said single weighting function ($w_{3-4,n}$; $w'_{3-4,n}$), as a function of n, are tabulated and stored in the memory of the decoder.

10. Method according to Claims 6 and 7, **characterized in that**:

- for n ranging from 0 to $(M+Ms)/2$, a primary expression $\hat{x}_n$ of the signal $\hat{x}_n$ to be decoded is calculated, according to a weighted combination of the type:

$$\widetilde{x}_n = w_{1,n}\tilde{l}_n + w_{3,n}s_{n-2M} + w_{4,n}s_{-M-1-n},$$

- for n between 0 and $M/2-Ms/2$, n = 0 corresponding to the start of a frame being decoded, assume:

* $\hat{x}_n = \widetilde{x}_n + w_{2,n}s_{M-1-n}$, and

- for n between $M/2-Ms/2$ and $M/2+Ms/2$, assume:

* $\hat{x}_n = \widetilde{x}_n + w'_{2,n}\tilde{s}_m$, with $m = n-M/2+Ms/2$.

11. Transform decoder, for a signal represented by a succession of frames derived from a coder using at least two types of weighting windows, of different respective lengths, **characterized in that** it comprises at least:

- means for receiving an indication of transition from a long window to a short window; and, to compensate for a direct transition from the long window to the short window:
- means for determining samples (**b**) from a decoding applying a short synthesis type of window (61) to a given frame ($T'_{i+1}$) that has been coded by using a short analysis window, and
- means of obtaining complementary samples (67, 69) able to:

 • partially decode (DCT$^{-1}$) a frame ($T'_i$) preceding the given frame and which has been coded by using a long analysis type of window, and
 • apply a combination of at least two values:

- derived from samples respectively of the given frame (T'$_{i+1}$) and of at least one frame (T'$_i$) preceding the given frame (T'$_{i+1}$),
- and weighted by respective weighting functions (w$_{1,n}$, w$_{2,n}$; w'$_{1,n}$, w'$_{2,n}$), tabulated and stored in the memory of a decoder.

**12.** Computer program, intended to be stored in the memory of a transform decoder, **characterized in that** it comprises instructions for implementing the decoding method according to one of Claims 1 to 10, when it is executed by a processor of such a decoder.

**13.** Transform decoder according to Claim 11, **characterized in that** it comprises a memory storing the instruction of a computer program according to Claim 12.

**Patentansprüche**

**1.** Verfahren zur Transformationsdecodierung eines Signals, das durch eine Folge von Rahmen dargestellt wird, die unter Verwendung von mindestens zwei Typen von Gewichtungsfenstern unterschiedlicher Längen codiert wurden, bei dem im Fall des Empfangs einer Information über den Übergang von einem langen Fenster zu einem kurzen Fenster, und um einen direkten Übergang vom langen Fenster zum kurzen Fenster zu kompensieren:

- Tastproben (b) ausgehend von einer Decodierung bestimmt werden (63), die einen kurzen Synthesefenstertyp (61) an einen gegebenen Rahmen (T'$_{i+1}$) anwendet, der unter Verwendung eines kurzen Analysefensters codiert wurde, und
- komplementäre Tastproben erhalten werden (67, 69), indem:

• ein Rahmen (T'$_i$), der vor dem gegebenen Rahmen liegt und unter Verwendung eines langen Analysefenstertyps codiert wurde, teilweise decodiert wird (DCT$^{-1}$), und
• eine Kombination von mindestens zwei Werten angewendet wird:

- die je von Tastproben des gegebenen Rahmens (T'$_{i+1}$) und mindestens eines vor dem gegebenen Rahmen (T'$_{i+1}$) liegenden Rahmens (T'$_i$) stammen,
- und durch jeweilige Gewichtungsfunktionen (W$_{1,n}$, w$_{2,n}$; w'$_{1,n}$, w'$_{2,n}$) gewichtet werden, die im Speicher eines Decoders tabelliert und gespeichert sind.

**2.** Verfahren nach Anspruch 1, **dadurch gekennzeichnet, dass**:

- zunächst die Tastproben (b) bestimmt werden (63), die von dem gegebenen Rahmen (T'$_{i+1}$) stammen, und
- daraus Tastproben (a) abgeleitet werden (65-67), die zeitlich dem Beginn des vorhergehenden Rahmens (T'$_i$) entsprechen, wobei diese Tastproben von einer Decodierung stammen, die ein langes Synthesefenster anwendet.

**3.** Verfahren nach Anspruch 2, bei dem:

- ein Rahmen M Tastproben aufweist,
- ein langes Fenster 2M Tastproben aufweist,
- ein kurze Fenster 2Ms Tastproben aufweist, wobei Ms geringer ist als M,
**dadurch gekennzeichnet, dass** die Tastproben $\hat{x}_n$, für n zwischen 0 und (M/2-Ms/2), wobei n=0 dem Beginn eines in Decodierung befindlichen Rahmens entspricht, durch eine Kombination von zwei gewichteten Termen des folgenden Typs angegeben werden:

$$\hat{x}_n = w_{1,n}\, \widetilde{l}_n + w_{2,n} s_{M-1-n},$$

wobei
- $\widetilde{l}_n$ Werte (v1) sind, die vom vorhergehenden Rahmen (T'$_i$) stammen,
- $s_{M-1-n}$ Tastproben (b) sind, die bereits unter Verwendung kurzer Synthesefenster, die an den gegebenen Rahmen (T'$_{i+1}$) angewendet wurden, decodiert wurden, und

- $w_{1,n}$ und $w_{2,n}$ Gewichtungsfunktionen sind, deren in Abhängigkeit von n angenommenen Werte im Speicher des Decoders tabelliert und gespeichert sind.

4. Verfahren nach einem der Ansprüche 1 bis 3, bei dem:

- ein Rahmen M Tastproben aufweist,
- ein langes Fenster 2M Tastproben aufweist,
- ein kurzes Fenster 2Ms Tastproben aufweist, wobei Ms geringer ist als M,
**dadurch gekennzeichnet, dass** die Tastproben $\hat{x}_n$, für n zwischen (M/2-Ms/2) und (M/2+Ms/2), wobei n=0 dem Beginn eines in Decodierung befindlichen Rahmens entspricht, durch eine Kombination von zwei gewichteten Termen des folgenden Typs angegeben werden:

$$\hat{x}_n \;=\; w'_{1,n}\,\widetilde{s}_m \;+\; w'_{2,n}\,\widetilde{l}_n, \;\; \mathtt{mit}\; m = n - M/2 + Ms/2,$$

wobei:
- $\widetilde{l}_n$ Werte (v1) sind, die vom vorhergehenden Rahmen ($T'_i$) stammen,
- $\widetilde{s}_m$ Werte (v2) sind, die vom gegebenen Rahmen ($T'_{1+i}$) stammen, und
- $w'_{1,n}$ und $w'_{2,n}$ Gewichtungsfunktionen sind, deren in Abhängigkeit von n angenommenen Werte im Speicher des Decoders tabelliert und gespeichert sind.

5. Verfahren nach einem der Ansprüche 1 bis 4, **dadurch gekennzeichnet, dass** für eine Decodierung von Rahmen, die durch eine Transformationscodierung mit Überlappung codiert wurden, um einen Einfluss vergangener Tastproben zu reduzieren, das zu decodierende Signal ausgehend von einer Kombination rekonstruiert wird aus:

- einer Gewichtung von Tastproben, die ausgehend von kurzen Fenstern rekonstruiert werden,
- einer Gewichtung von Tastproben, die teilweise ausgehend von einem langen Fenster rekonstruiert werden, und
- einer Gewichtung von Tastproben des vergangenen decodierten Signals.

6. Verfahren nach Anspruch 5, **dadurch gekennzeichnet, dass** mit:

- einem M Tastproben aufweisenden Rahmen,
- einem 4M Tastproben enthaltenden langen Fenster,
- einem 2Ms Tastproben enthaltenden kurzen Fenster, wobei Ms geringer ist als M,
für einen Tastprobenindex n zwischen 0 und M/2-Ms/2, wobei n=0 dem Beginn eines in Decodierung befindlichen Rahmens entspricht, die zu decodierenden Tastproben $\widetilde{x}_n$ durch eine Kombination von vier gewichteten Termen des folgenden Typs angegeben werden:

$$\hat{x}_n \;=\; w_{1,n}\,\widetilde{l}_n \;+\; w_{2,n}S_{M-1-n} \;+\; w_{3,n}S_{n-2M} \;+\; w_{4,n}S_{-M-1-n},$$

mit $0 \leq n < M/2-Ms/2$,
wobei:
- die Schreibweise $\hat{l}_n = z_{t,n+M}+z_{t,n+2M}+z_{t-2,n+3M}$ unvollständig decodierte Tastproben des Rahmens ($T'_i$) bezeichnet, der vor dem gegebenen Rahmen ($T'_{i+1}$) liegt, indem ein langes Synthesefenster mit Addition ohne Korrektur zu vorhergehenden Speicherelementen verwendet wird, die mit $z_{t-1,n+2M}+z_{t-2,n+3M}$ bezeichnet sind, wobei der Index t ein Rahmenindex ist,
- $S_n$ mit Hilfe einer Folge von kurzen Synthesefenstern (FCS) des gegebenen Rahmens ($T'_{i+1}$), für M/2 + Ms/2 ≤ n < M, vollständig decodierte Tastproben und vollständig decodierte Tastproben vorhergehender Rahmen ($T'_i$, $T'_{i-1}$, $T'_{i-2}$, ...), für - 2M ≤ n < M, darstellt, und
- $w_{1,n}$, $w_{2,n}$, $w_{3,n}$ und $w_{4,n}$ erste, zweite, dritte bzw. vierte Gewichtungsfunktionen sind, die vom Tastprobenindex n abhängen, und die von mindestens den ersten und zweiten Gewichtungsfunktionen $w_{1,n}$ und $w_{2,n}$ in Abhängigkeit von n angenommenen Werte im Speicher des Decoders tabelliert und gespeichert werden.

7. Verfahren nach einem der Ansprüche 5 und 6, **dadurch gekennzeichnet, dass** mit:

- einem M Tastproben enthaltenden Rahmen,
- einem 4M Tastproben enthaltenden langen Fenster,
- einem 2Ms Tastproben enthaltenden kurzen Fenster, wobei Ms geringer ist als M,

für n zwischen M/2-Ms/2 und M/2+Ms/2 die zu decodierenden Tastproben $\hat{x}_n$ durch eine Kombination von vier gewichteten Termen des Typs angegeben werden:

$$\hat{x}_n \;=\; w'_{1,n}\,\tilde{l}_n \;+\; w'_{2,n}\,\tilde{s}_m \;+\; w'_{3,n}s_{n-2M} \;+\; w'_{4,n}s_{-M-1-n},$$

wobei:
- $\hat{l}_n$ unvollständig decodierte Tastproben des Rahmens ($T'_i$) sind, der vor dem gegebenen Rahmen ($T'_{i+1}$) liegt,
- $\tilde{s}_m$ unvollständig decodierte Tastproben des ersten kurzen Fensters des gegebenen Rahmens ($T'_{i+1}$) sind, mit m = n - M/2 + Ms/2,
- $s_n$ die vollständig decodierten Tastproben vorhergehender Rahmen ($T'_i$, $T'_{i-1}$, $T'_{i-2}$, ...) darstellt,
- $w'_{1,n}$, $w'_{2,n}$, $w'_{3,n}$ und $w'_{4,n}$ erste, zweite, dritte bzw. vierte von n abhängende Gewichtungsfunktionen sind, und die Werte, die von mindestens der ersten und der zweiten Gewichtungsfunktion $W'_{1,n}$ und $W'_{2,n}$ abhängig von n angenommen werden, im Speicher des Decoders tabelliert und gespeichert werden.

8. Verfahren nach einem der Ansprüche 6 und 7, **dadurch gekennzeichnet, dass** die Beiträge der dritten und vierten Gewichtungsfunktionen ($w_{3,n}$, $w_{4,n}$; $w'_{3,n}$, $w'_{4,n}$) bei der Berechnung der Tastproben $\hat{x}_n$ vernachlässigt werden, so dass nur die von den ersten und zweiten Gewichtungsfunktionen ($w_{1,n}$, $w_{2,n}$; $w'_{1,n}$, $w'_{2,n}$), in Abhängigkeit von n angenommenen Werte im Speicher des Decoders tabelliert und gespeichert werden.

9. Verfahren nach einem der Ansprüche 6 und 7, **dadurch gekennzeichnet, dass** die dritte und vierte Gewichtungsfunktion ($w_{3,n}$, $w_{4,n}$; $w'_{3,n}$, $w'_{4,n}$) durch eine einzige Gewichtungsfunktion ($w_{3-4,n}$; $w'_{3-4,n}$) angegeben werden, die aus einer linearen Kombination der dritten und vierten Gewichtungsfunktion ($w_{3,n}$, $w_{4,n}$; $w'_{3,n}$, $w'_{4,n}$) hervorgeht, so dass nur die von der ersten und zweiten Gewichtungsfunktion ($w_{1,n}$, $w_{2,n}$; $w'_{1,n}$, $w'_{2,n}$) angenommenen Werte sowie die von der einzigen Gewichtungsfunktion ($w_{3-4,n}$; $w'_{3-4,n}$) in Abhängigkeit von n angenommenen Werte im Speicher des Decoders tabelliert und gespeichert werden.

10. Verfahren nach den Ansprüchen 6 und 7, **dadurch gekennzeichnet, dass**:

- für n von 0 bis (M+Ms)/2 ein primärer Ausdruck $\tilde{x}_n$ des zu decodierenden Signals $\hat{x}_n$ gemäß einer gewichteten Kombination des folgenden Typs berechnet wird:

$$\tilde{x}_n \;=\; w_{1,n}\,\tilde{l}_n \;+\; w_{3,n}s_{n-2M} \;+\; w_{4,n}s_{-M-1-n},$$

- für n zwischen 0 und M/2-Ms/2, wobei n=0 dem Beginn eines in Decodierung befindlichen Rahmens entspricht, vorausgesetzt wird:

$\star \qquad \hat{x}_n \;=\; \tilde{x}_n \;+\; w_{2,n}s_{M-1-n},$ und

- für n zwischen M/2-Ms/2 und M/2+Ms/2 vorausgesetzt wird: $\star \qquad \hat{x}_n \;=\; \tilde{x}_n \;+\; w'_{2,n}\,\tilde{s}_m,$ mit

$m = n-M/2+Ms/2.$

11. Transformationsdecoder eines Signals, das durch eine Folge von Rahmen dargestellt wird, die von einem Codierer stammen, der mindestens zwei Gewichtungsfenstertypen unterschiedlicher Länge verwendet, **dadurch gekennzeichnet, dass** er mindestens aufweist:

- Einrichtungen zum Empfang einer Information über den Übergang von einem langen Fenster zu einem kurzen Fenster; und um einen direkten Übergang vom langen Fenster zum kurzen Fenster zu kompensieren:
- Einrichtungen zur Bestimmung von Tastproben (b) ausgehend von einer Decodierung, die einen kurzen Synthesefenstertyp (61) an einen gegebenen Rahmen ($T'_{i+1}$) anwendet, der unter Verwendung eines kurzen Analysefensters codiert wurde, sowie

**EP 2 104 936 B1**

- Einrichtungen zum Erhalt komplementärer Tastproben (67, 69), die fähig sind:

• einen Rahmen ($T'_i$), der vor dem gegebenen Rahmen liegt und unter Verwendung eines langen Analysefenstertyps codiert wurde, teilweise zu decodieren ($DCT^{-1}$), und
• eine Kombination von mindestens zwei Werten anzuwenden:

- die von Tastproben des gegebenen Rahmens ($T'_{i+1}$) bzw. mindestens eines dem gegebenen Rahmen ($T'_{i+1}$) vorausgehenden Rahmens ($T'_i$) stammen,
- und durch jeweilige Gewichtungsfunktionen ($W_{1,n}$, $w_{2,n}$; $w'_{1,n}$, $w'_{2,n}$) gewichtet werden, die im Speicher eines Decoders tabelliert und gespeichert sind.

12. EDV-Programm, dazu bestimmt, im Speicher eines Transformationsdecoders gespeichert zu werden, **dadurch gekennzeichnet, dass** es Anweisungen zur Durchführung des Decodierverfahrens nach einem der Ansprüche 1 bis 10 aufweist, wenn es von einem Prozessor eines solchen Decoders ausgeführt wird.

13. Transformationsdecoder nach Anspruch 11, **dadurch gekennzeichnet, dass** er einen Speicher aufweist, der die Anweisungen eines EDV-Programms nach Anspruch 12 speichert.

FIG. 1

FIG. 1a

FIG. 1b

FIG. 1c

EP 2 104 936 B1

**FIG. 2a**

**FIG. 2b**

FIG. 2c

FIG. 2d

FIG. 2e

FIG. 3a

xin

$T_{i-1}$　　　　$T_i$　　　$T_{i+1}$

n

n

FL

e　　f

Calc T'$_i$

$v_1 = e*h(M+n)+f*h(2*M-1-n)$

FC

m

Calc T'$_{i+1}$

e　　f

m

$v_2 = f*h_s(M_s-1-m)-e*h_s(m)$

FLS

DEC

FCS

$v_1 = e*h(M+n)+f*h(2*M-1-n)$　　　$v_2 = f*h_s(M_s-1-m)-e*h_s(m)$

**FIG. 3b**

## FIG. 4a

## FIG. 4b

FIG. 5a

FIG. 6

**FIG. 5b**

FIG. 7

FIG. 8

# FIG. 9

# FIG. 10

## FIG. 11

## FIG. 12

# EP 2 104 936 B1

## RÉFÉRENCES CITÉES DANS LA DESCRIPTION

**Littérature non-brevet citée dans la description**

- **Gerald D. T. Schuller ; Tanja Karp.** Modulated Filter Banks with Arbitrary System Delay: Efficient Implementations and the Time- Varying Case. *IEEE Transactions on Signal Processing,* Mars 2000, vol. 48 (3